# EUROPEAN PATENT APPLICATION

(11) **EP 4 561 309 A1**
(43) Date of publication of application: **28.05.2025**
(21) Application number: 23842995.5
(22) Date of filing: 19.07.2023
(51) Int. Cl.: H10K 50/12, H10K 71/16, H10K 85/10, H10K 85/30, H10K 85/60, H10K 101/10, H10K 101/20

(54) **ORGANIC ELECTROLUMINESCENT ELEMENT**

(30) Priority: 22.07.2022 JP 2022117474
(71) Applicant: NIPPON STEEL CHEMICAL & MATERIAL CO., LTD., Tokyo 103-0027 (JP)
(72) Inventor: OGAWA, Junya, Tokyo 103-0027 (JP); SHIMAMOTO, Yuya, Tokyo 103-0027 (JP)
(74) Representative: Kraus & Lederer PartGmbB
(86) International application number: PCT/JP2023/026358
(87) International publication number: WO 2024/019072

(57) **Abstract**

To provide a practically useful organic electroluminescent device having a low voltage, high efficiency and extended lifetime characteristics. Specifically provided is an organic electroluminescent device comprising a light-emitting layer containing a first host as indolocarbazole derivative represented by the following general formula (1), a second host as a biscarbazole derivative represented by the following general formula (2), and a light-emitting dopant material: 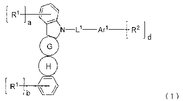 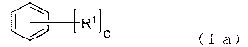 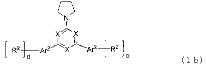 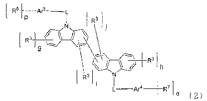 wherein, ring G is represented by a formula (1a), ring H is represented by a formula (1b), L¹ represents, for example, a single bond, X represents, for example, N, Ar¹ and Ar² each represent, for example, an aromatic hydrocarbon group or an aromatic hetero group, provided that at least one of Ar¹ and Ar² represents, for example, a phenyldibenzofuran group, R¹ and R² each represent, for example, deuterium, Ar³ and Ar⁴ each represent, for example, an aromatic hydrocarbon group, L represents, for example, a single bond, and R³, R⁶, and R⁷ each represent, for example, deuterium.

## Description

### Technical Field

The present invention relates to an organic electroluminescent element or device (hereinafter, referred to as an organic EL device), and specifically relates to an organic EL device comprising a specific mixed host material.

### Background Art

Application of a voltage to an organic EL device allows injection of holes and electrons from an anode and a cathode, respectively, into a light-emitting layer. Then, in the light-emitting layer, injected holes and electrons recombine to generate excitons. At this time, according to statistical rules of electron spins, singlet excitons and triplet excitons are generated at a ratio of 1:3. Regarding a fluorescence-emitting organic EL device using light emission from singlet excitons, it is said that the internal quantum efficiency thereof has a limit of 25%. Meanwhile, regarding a phosphorescent organic EL device using light emission from triplet excitons, it is known that intersystem crossing is efficiently performed from singlet excitons, the internal quantum efficiency is enhanced to 100%.

Highly efficient organic EL devices utilizing delayed fluorescence have been developed recently. For example, Patent Literature 1 discloses an organic EL device utilizing a TTF (Triplet-Triplet Fusion) mechanism, which is one of delayed fluorescence mechanisms. The TTF mechanism utilizes a phenomenon in which singlet excitons are generated due to collision of two triplet excitons, and it is thought that the internal quantum efficiency can be theoretically raised to 40%. However, since the efficiency is lower compared to phosphorescent organic EL devices, further improvement in efficiency and low voltage characteristics are required.

In addition, patent Literature 2 discloses an organic EL device utilizing a TADF (Thermally Activated Delayed Fluorescence) mechanism. The TADF mechanism utilizes a phenomenon in which reverse intersystem crossing from triplet excitons to singlet excitons is generated in a material having a small energy difference between a singlet level and a triplet level, and it is thought that the internal quantum efficiency can be theoretically raised to 100%.

However, all the mechanisms have room for advancement in terms of both efficiency and lifetime, and are additionally required to be improved also in terms of reduction in driving voltage.

### Citation List

### Patent Literature

Patent Literature 1: WO2010/134350 A
Patent Literature 2: WO2011/070963 A
Patent Literature 3: WO2008/056746 A
Patent Literature 4: WO2018/198844 A
Patent Literature 5: US10333077B2 A
Patent Literature 6: CN111233847 A
Patent Literature 7: KR2019-0009211 A
Patent Literature 8: KR2019-0001357 A
Patent Literature 9: WO2013/122402 A
Patent Literature 10: KR2021-0062771 A

Patent Literature 3 discloses use of an indolocarbazole compound as a host material of a light-emitting layer.

Patent Literatures 4 and 5 disclose use of an indolocarbazole compound and a biscarbazole compound in a mixed host material of a light-emitting layer.

Patent Literatures 6, 7, and 8 disclose use of an indolocarbazole compound substituted with a phenyldibenzofuran group in a host material of a light-emitting layer.

Patent Literatures 9 and 10 disclose use of an indolocarbazole compound substituted with a phenyldibenzofuran group and a biscarbazole compound in a mixed host material of a light-emitting layer.

However, none of these can be said to be sufficient, and further improvement is desired.

### Summary of Invention

### Technical Problem

Organic EL displays, when compared with liquid crystal displays, are not only characterized by being thin-and-light, high in contrast, and capable of displaying a high-speed moving picture, but also highly valued in terms of designability such as curving and flexibility, and are widely applied in display apparatuses including mobiles and TV. However, organic EL displays are needed to be further reduced in voltage in order to suppress battery consumption in the case of use thereof for mobile terminals, and are inferior as light sources in terms of luminance and lifetime as compared with inorganic LEDs and thus are demanded to be improved in efficiency and enhanced in device lifetime. In view of the above circumstances, an object of the present invention is to provide a practically useful organic EL device having a low voltage, high efficiency and lifetime characteristics.

### Solution to Problem

As a result of intensive studies, the present inventors have found that the above problems can be solved by an organic electroluminescent device in which a specific mixed host material is used in a light-emitting layer, and have completed the present invention.

The present invention relates to an organic electroluminescent device comprising one or more light-emitting layers between an anode and a cathode opposed to each other, wherein at least one of the light-emitting layers contains a first host selected from a compound represented by the following general formula (1), a second host selected from a compound represented by the following general formula (2), and a light-emitting dopant material.

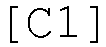

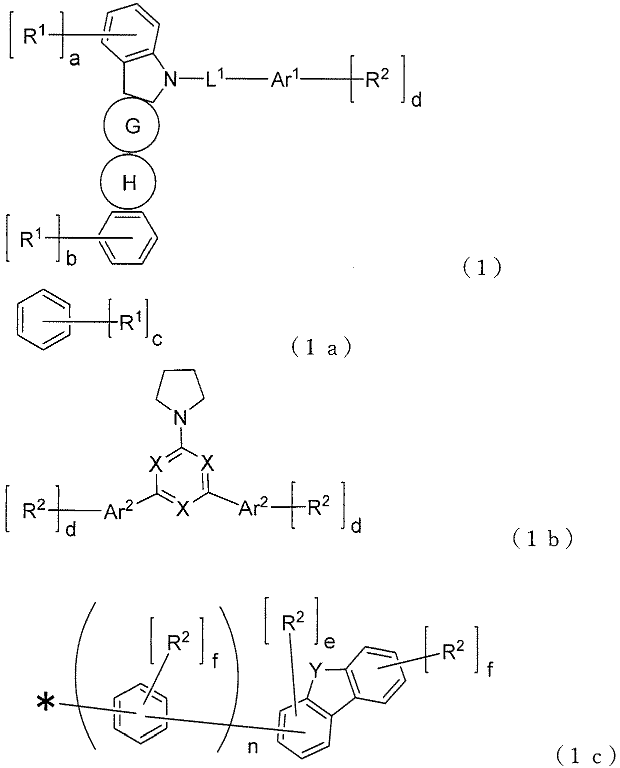

In the general formula (1), ring G represents an aromatic ring represented by a formula (1a), and is fused with two adjacent rings. Ring H represents a heterocyclic ring represented by a formula (1b), and is fused with two adjacent rings at any positions, but not fused on a side containing N.

Each X independently represents N, C-H, or C-R and at least one thereof represents N. Y represents O or S.

Ar¹ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other.

Ar² independently represents a substituted or unsubstituted aromatic hydrocarbon group having 6 to 17 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other.

Here, at least one of Ar¹ and two Ar² represents a group represented by a formula (1c). "*" indicates a bonding position.

L¹ represents a single bond, a substituted or unsubstituted aromatic hydrocarbon group having 6 to 18 carbon atoms, or a substituted or unsubstituted aromatic heterocyclic group having 3 to 17 carbon atoms, and
each R¹ independently represents deuterium, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other. Here, when R¹ is an aromatic hydrocarbon group, R¹ is optionally fused with the benzene ring to which R¹ is bonded to form a ring.

Each R² independently represents deuterium or an aliphatic hydrocarbon group having 1 to 10 carbon atoms, a to f represent the number of substitutions, a and b each independently represent an integer of 0 to 4, c represents an integer of 0 to 2, each d independently represents an integer of 0 to 13, e represents an integer of 0 to 3, and each f independently represents an integer of 0 to 4. n represents the number of repetitions and an integer of 1 to 4.

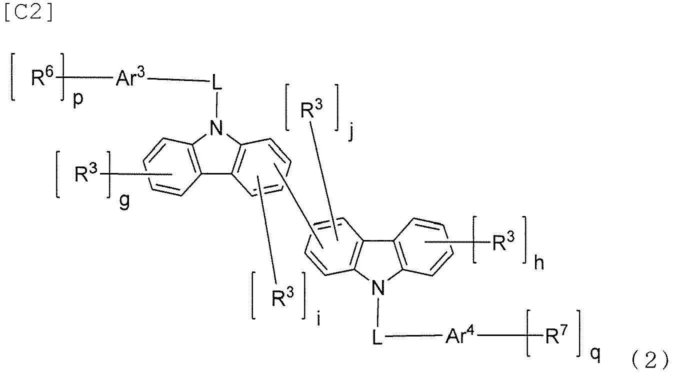

In the formula (2), Ar³ and Ar⁴ each independently represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of these aromatic groups are linked to each other.

Each L independently represents a single bond, a substituted or unsubstituted aromatic hydrocarbon group having 6 to 18 carbon atoms, or a substituted or unsubstituted aromatic heterocyclic group having 3 to 17 carbon atoms, and

R³, R⁶, and R⁷ each independently represent deuterium or an aliphatic hydrocarbon group having 1 to 10 carbon atoms.

g to j and p to q represent the number of substitutions, g and h each independently represent an integer of 0 to 4, i and j each independently represent an integer of 0 to 3, and p and q each independently represent an integer of 0 to 12.

In a preferred aspect of the present invention, any of the following is satisfied: all of X representing N, R¹ representing deuterium, R² representing deuterium, or Y representing O, in the general formula (1).

In an aspect, at least one of Ar² is represented by any of formulas (3) to (5) in the general formula (1), and an aspect in which at least one of Ar² is represented by a formula (3) is more preferred.

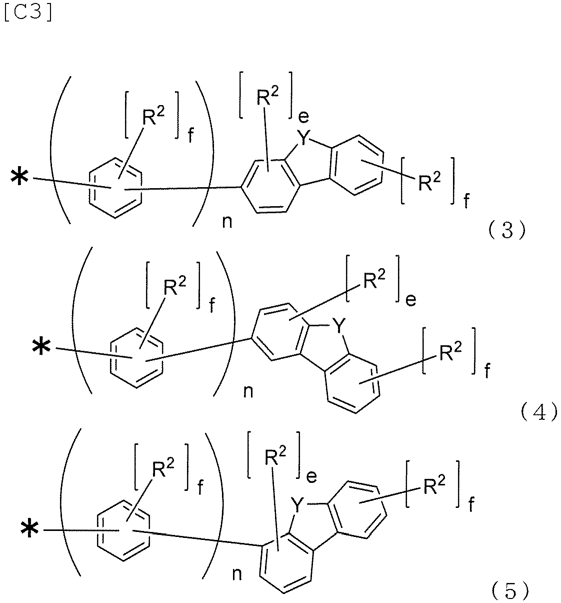

In an aspect, the compound represented by the general formula (1) is represented by any of the following formulas (6) to (9).

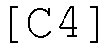

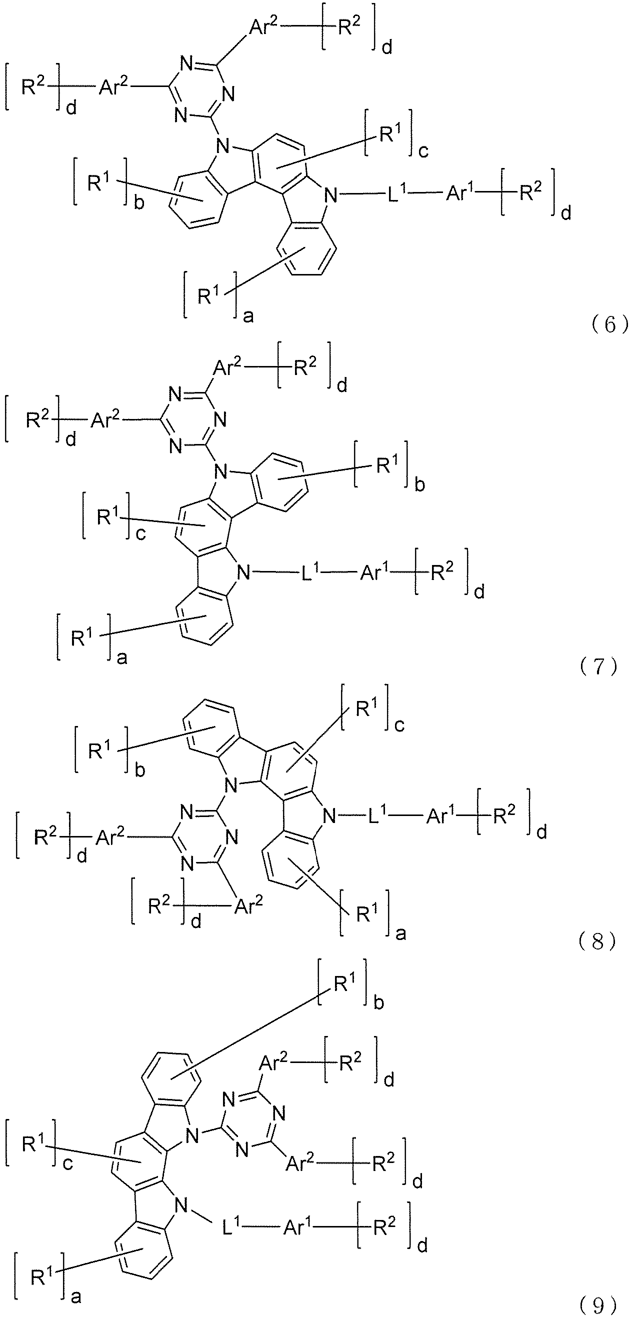

It is preferable for the compound represented by the general formula (2) that Ar³ and Ar⁴ each independently represent a substituted or unsubstituted aromatic hydrocarbon group having 6 to 18 carbon atoms, or a substituted or unsubstituted linked aromatic group in which two to three aromatic rings of such an aromatic group are linked to each other, and it is more preferable that Ar³ and Ar⁴ each independently represent a substituted or unsubstituted phenyl group, a substituted or unsubstituted biphenyl group, or a substituted or unsubstituted terphenyl group. It is preferable for the compound represented by the general formula (2) that R³ represents deuterium. In a preferred aspect of the present invention, the compound represented by the general formula (2) satisfies either that Ar³ and Ar⁴ each represent a substituted or unsubstituted phenyl group, a substituted or unsubstituted biphenyl group, or a substituted or unsubstituted terphenyl group, or that R³ represents deuterium.

In an aspect, the compound of the general formula (2) is represented by the following formula (10).

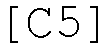

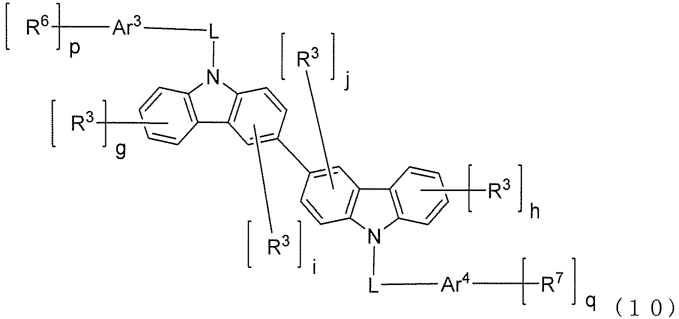

The organic electroluminescent device of the present invention comprises a light-emitting layer having a mixed host containing two compounds and having a dopant (light-emitting dopant material). In the organic electroluminescent device, the ratio of the compound represented by the general formula (1) to the total of the compound represented by the general formula (1) and the compound represented by the general formula (2) in the mixed host is preferably 10 wt% or more and less than 80 wt%, and more preferably 20 wt% or more and less than 70 wt%. It is more preferable that the light-emitting dopant be an organic metal complex containing at least one metal selected from the group consisting of ruthenium, rhodium, palladium, silver, rhenium, osmium, iridium, platinum and gold, or a thermally activated delayed fluorescence-emitting dopant.

The present invention relates to a premixture comprising a first host and a second host to be used for forming a light-emitting layer for an organic electroluminescent device comprising a light-emitting layer containing hosts and a light-emitting dopant material between an anode and a cathode opposed to each other, wherein the first host is selected from the compound represented by the general formula (1) and the second host is selected from the compound represented by the general formula (2).

Production of the organic electroluminescent device preferably comprises a step of mixing the first host represented by the general formula (1) and the second host represented by the general formula (2) to give a premixture and then vapor-depositing a host material containing the premixture to form a light-emitting layer.

In a method for producing the organic electroluminescent device, a difference in temperature at 50% weight loss of the first host and the second host is preferably within 20°C.

### Advantageous Effect of Invention

According to the present invention, a first host having indolocarbazole, a nitrogen-containing six-membered ring, and a phenyldibenzofuran group or phenyldibenzothiophene group and a biscarbazole compound as a second host can be mixed and used to thereby obtain an organic EL device with high efficiency and extended lifetime in spite of having a low voltage.

### Brief Description of Drawing

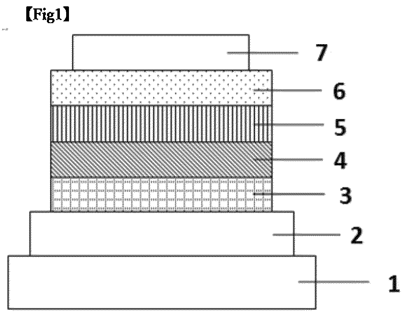

[Figure 1] Figure 1 is a schematic cross-sectional view showing one example of an organic EL device.

### Description of Embodiments

The organic electroluminescent device of the present invention is an organic electroluminescent device comprising a plurality of organic layers between an anode and a cathode, wherein the organic layers include at least one light-emitting layer, and the light-emitting layer contains a first host represented by the general formula (1), a second host represented by the general formula (2), and a light-emitting dopant material.

In the general formula (1), ring G represents an aromatic ring represented by the formula (1a), and is fused with two adjacent rings. Ring H represents a five-membered heterocyclic ring represented by the formula (1b), and is fused with two adjacent rings at any positions, but not fused on a side containing N. Accordingly, the indolocarbazole ring has some isomeric structures, though the number is limited. Having different isomeric structures of the indolocarbazole ring, the compound represented by the general formula (1) is specifically represented as any of the structures represented by the formulas (6) to (9), and in a preferred aspect the compound is represented as any of the structures represented by the formulas (7) to (9), and in a more preferred aspect represented as the structure represented by the formula (9).

In the general formula (1) and the formulas (6) to (9), the same symbols have the same meaning. Each X independently represents N, C-H, or C-R and at least one thereof represents N. Preferably, at least two X represent N; more preferably, all of X represent N.

In the formula (1c) and the formulas (3) to (5), the same symbols have the same meaning. The formula (1c) can be represented by the formulas (3) to (5), and at least one of Ar² is preferably represented by any of the formulas (3) to (5), and more preferably represented by the formula (3).

Each Y independently represents O or S, and preferably represents O.

a to f represent the number of substitutions, a, b, and f each independently represent an integer of 0 to 4, c represents an integer of 0 to 2, each d independently represents an integer of 0 to 13, and e represents an integer of 0 to 3. n represents the number of repetitions and an integer of 1 to 4. Preferably, a and b each independently represent an integer of 1 to 4, c represents an integer of 1 to 2, each f independently represents an integer of 0 or 4, and n represents an integer of 1 or 2; more preferably, a and b each independently represent an integer of 4, and c represents an integer of 2.

Each Ar¹ independently represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of these aromatic groups are linked to each other, or a group represented by the formula (1c). Preferably, each Ar¹ independently represents a substituted or unsubstituted aromatic hydrocarbon group having 6 to 18 carbon atoms or a substituted or unsubstituted linked aromatic group in which two to five such aromatic hydrocarbon groups are linked to each other, or a group represented by the formula (1c). More preferably, each Ar¹ independently represents a substituted or unsubstituted phenyl group or a substituted or unsubstituted linked aromatic group in which two to three phenyl groups are linked to each other. The mode of linking between phenyl groups is meta- or para-linkage.

Each Ar² independently represents a substituted or unsubstituted aromatic hydrocarbon group having 6 to 17 carbon atoms, a substituted or unsubstituted aromatic heterocyclic group having 3 to 17 carbon atoms, or a substituted or unsubstituted linked aromatic group in which two to five aromatic rings of these aromatic groups are linked to each other, or a group represented by the formula (1c). Preferably, each Ar² independently represents a substituted or unsubstituted aromatic hydrocarbon group having 6 to 17 carbon atoms or a substituted or unsubstituted linked aromatic group in which two to five such aromatic hydrocarbon groups are linked to each other, or a group represented by the formula (1c). More preferably, each Ar² independently represents a substituted or unsubstituted phenyl group or a substituted or unsubstituted linked aromatic group in which two to three phenyl groups are linked to each other, or a group represented by the formula (1c).

At least one of Ar¹ and two Ar² represents a group represented by the formula (1c).

L¹ represents a single bond, a substituted or unsubstituted aromatic hydrocarbon group having 6 to 18 carbon atoms, or a substituted or unsubstituted aromatic heterocyclic group having 3 to 17 carbon atoms. Preferably, L¹ represents a single bond, or a substituted or unsubstituted phenylene group, and the mode of linking between phenylene groups may be either meta- or para-linkage.

Specific examples of the unsubstituted aromatic hydrocarbon group having 6 to 18 carbon atoms, the unsubstituted aromatic heterocyclic group having 3 to 17 carbon atoms, or the linked aromatic group in which two to five of these aromatic rings are linked to each other for Ar¹ include a group generated by removing one hydrogen from benzene, naphthalene, acenaphthene, acenaphthylene, azulene, anthracene, chrysene, pyrene, phenanthrene, fluorene, triphenylene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzoisothiazole, benzothiadiazole, purine, pyranone, coumarin, isocoumarin, chromone, dibenzofuran, dibenzothiophene, dibenzoselenophene, carbazole, or compounds in which two to five of these are linked to each other. Preferred examples thereof include a group generated from benzene, naphthalene, acenaphthene, acenaphthylene, azulene, anthracene, chrysene, pyrene, phenanthrene, fluorene, triphenylene, or compounds in which two to five of these are linked to each other. More preferred is a phenyl group, a biphenyl group, or a terphenyl group. The terphenyl group may be linked linearly or branched.

Specific examples of the unsubstituted aromatic hydrocarbon group having 6 to 17 carbon atoms, the unsubstituted aromatic heterocyclic group having 3 to 17 carbon atoms, or the linked aromatic group in which two to five aromatic rings of these aromatic groups are linked to each other for Ar² include a group generated by removing one hydrogen from benzene, naphthalene, acenaphthene, acenaphthylene, azulene, anthracene, pyrene, phenanthrene, fluorene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzoisothiazole, benzothiadiazole, purine, pyranone, coumarin, isocoumarin, chromone, dibenzofuran, dibenzothiophene, dibenzoselenophene, carbazole, or compounds in which two to five of these are linked to each other. Preferred examples thereof include a group generated from benzene, naphthalene, acenaphthene, acenaphthylene, azulene, anthracene, pyrene, phenanthrene, fluorene, or compounds in which two to five of these are linked to each other. More preferred is a phenyl group, a biphenyl group, or a terphenyl group. The terphenyl group may be linked linearly or branched.

When L¹ represents an unsubstituted aromatic hydrocarbon group having 6 to 18 carbon atoms, L¹ is the same as in the case that Ar¹ represents an unsubstituted aromatic hydrocarbon group having 6 to 18 carbon atoms, except that L¹ represents a group generated by removing two hydrogen. Preferably, L¹ represents a substituted or unsubstituted phenylene group.

Each R¹ independently represents deuterium, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other. Preferably, each R¹ independently represents deuterium or a substituted or unsubstituted phenyl group. More preferably, each R¹ independently represents deuterium. When R¹ represents an aromatic hydrocarbon group, R¹ is optionally fused with the benzene ring to which R¹ is bonded to form a ring.

Specific examples of the unsubstituted aromatic hydrocarbon group having 6 to 18 carbon atoms, the unsubstituted aromatic heterocyclic group having 3 to 17 carbon atoms, or the unsubstituted linked aromatic group in which two to five aromatic rings of these aromatic groups are linked to each other for R¹ are the same as those for Ar¹.

Each R² independently represents deuterium or an aliphatic hydrocarbon group having 1 to 10 carbon atoms. Preferably, each R² independently represents deuterium.

Specific examples of the aliphatic hydrocarbon group having 1 to 10 carbon atoms include methyl, ethyl, propyl, butyl, pentyl, hexyl, heptyl, octyl, nonyl, and decyl. Preferred is an alkyl group having 1 to 4 carbon atoms.

In the general formula (2), the two carbazole rings can be bonded at the 2-position, the 3-position, or the 4-position, but preferred is bonding at the 3-position as shown in the formula (10). In the general formula (2) and the formula (10), the same symbols have the same meaning.

Ar³ and Ar⁴ each independently represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of these aromatic groups are linked to each other. Preferred is a substituted or unsubstituted aromatic hydrocarbon group having 6 to 18 carbon atoms, or a linked aromatic group in which two to three of these aromatic rings of these aromatic hydrocarbon groups are linked to each other, and more preferred is a substituted or unsubstituted phenyl group, a substituted or unsubstituted biphenyl group, a substituted or unsubstituted terphenyl group. The terphenyl group may be linked linearly or branched. Specific examples of the unsubstituted aromatic hydrocarbon group having 6 to 18 carbon atoms, the unsubstituted aromatic heterocyclic group having 3 to 17 carbon atoms, or the linked aromatic group in which two to five of these aromatic rings are linked to each other for Ar³ and Ar⁴ are the same as those shown for Ar¹.

Each L independently represents a single bond, a substituted or unsubstituted aromatic hydrocarbon group having 6 to 18 carbon atoms, or a substituted or unsubstituted aromatic heterocyclic group having 3 to 17 carbon atoms. Preferably, each L independently represents a single bond or a substituted or unsubstituted phenylene group. The mode of linking may be any of ortho-, meta-, or para-linkage. Specific examples of the unsubstituted aromatic hydrocarbon group having 6 to 18 carbon atoms or the unsubstituted aromatic heterocyclic group having 3 to 17 carbon atoms for L are the same as those shown for Ar¹, except that L represents a group generated by removing two hydrogen.

R³, R⁶, and R⁷ each independently represent deuterium or an aliphatic hydrocarbon group having 1 to 10 carbon atoms. Preferably, R³, R⁶, and R⁷ each independently represent deuterium. Specific examples of the aliphatic hydrocarbon group having 1 to 10 carbon atoms are the same as those shown for R².

g to j and p to q represent the number of substitutions, g and h each independently represent an integer of 0 to 4, i and j each independently represent an integer of 0 to 3, and p and q each independently represent an integer of 0 to 12. Preferably, g and h each independently represent an integer of 1 to 4, i and j each independently represent an integer of 1 to 3, and p and q each independently represent an integer of 1 to 12; more preferably, g and h each independently represent an integer of 4, and i and j each independently represent an integer of 3.

In the present specification, the linked aromatic group refers to an aromatic group in which the aromatic rings in two or more aromatic groups are linked to each other by a single bond. The linked aromatic group may be linear or branched. The linkage position in linking of benzene rings may be any of the ortho-, meta-, and para-positions, and is preferably the para-position or the meta-position. The aromatic group may be an aromatic hydrocarbon group or an aromatic heterocyclic group, and the plurality of aromatic groups may be the same or different.

In the present specification, the aromatic hydrocarbon group, the aromatic heterocyclic group, or the linked aromatic group may have a substituent. In the case that a substituent is contained, the substituent is preferably deuterium, a halogen, a cyano group, a triarylsilyl group, an aliphatic hydrocarbon group having 1 to 10 carbon atoms, an alkenyl group having two to five carbon atoms, an alkoxy group having one to five carbon atoms, or a diarylamino group having 12 to 44 carbon atoms. When the substituent is an aliphatic hydrocarbon group having 1 to 10 carbon atoms, the substituent may be linear, branched, or cyclic. When the triarylsilyl group or the diarylamino group substitutes the aromatic hydrocarbon group, the aromatic heterocyclic group, or the linked aromatic group, silicon and carbon or nitrogen and carbon are bonded together by a single bond.

The number of substituents is preferably 0 to 5, and more preferably 0 to 2. In calculating the number of carbon atoms when the aromatic hydrocarbon group and the aromatic heterocyclic group have a substituent, the number of carbon atoms of the substituent is not included. However, it is preferable that the total number of carbon atoms including the number of carbon atoms of the substituent satisfy the above range.

Specific examples of the substituent include deuterium, cyano, methyl, ethyl, propyl, i-propyl, butyl, t-butyl, pentyl, neopentyl, cyclopentyl, hexyl, cyclohexyl, heptyl, octyl, nonyl, decyl, vinyl, propenyl, butenyl, pentenyl, methoxy, ethoxy, propoxy, butoxy, pentoxy, diphenylamino, naphthylphenylamino, dinaphthylamino, dinthranylamino, diphenanthrenylamino, and dipyrenylamino. Preferred examples thereof include deuterium, cyano, methyl, ethyl, t-butyl, propyl, butyl, pentyl, neopentyl, hexyl, heptyl, or octyl, diphenylamino, naphthylphenylamino, or dinaphthylamino.

Some or all hydrogen atoms of the unsubstituted aromatic hydrocarbon group, the unsubstituted aromatic heterocyclic group, the unsubstituted linked aromatic group, the substituents of these aromatic groups, or the aliphatic hydrocarbon group may be deuterated. In other words, some or all of hydrogen in the compounds represented by the general formulas (1) to (2) and the formulas (6) to (10) may be deuterium. A deuterated product encompasses both the case of a single compound included and the case of a mixture of two or more compounds included. In other words, the rate of deuteration is specifically described, and means that half the total hydrogen, on average, is substituted with deuterium in the case of a rate of deuteration of 50%, in which the deuterated product may be a single compound or a mixture of those different in rate of deuteration.

When some of hydrogen in the compounds represented by the general formulas (1) to (2) and the formulas (6) to (10) are deuterium, preferably 20% or more of hydrogen atoms are deuterium, more preferably 40% or more thereof are deuterium, and further preferably 50% or more thereof are deuterium.

The rate of deuteration can be determined by mass analysis or proton nuclear magnetic resonance spectroscopy. For example, when the rate of deuteration is determined by proton nuclear magnetic resonance spectroscopy, first, a measurement sample is prepared by adding and dissolving a compound and an internal standard material to and in a deuterated solvent, and the proton concentration [mol/g] in the compound included in the measurement sample is calculated from the ratio between the respective integral intensities derived from the internal standard material and the compound. Next, the ratio between the proton concentration in a deuterated compound and the proton concentration in the corresponding non-deuterated compound is calculated, and subtracted from 1, thereby enabling calculation of the rate of deuteration of the deuterated compound. The rate of deuteration of a partial structure can be calculated from the integral intensity of the chemical shift derived from an objective partial structure, according to the same procedure.

Specific examples of the compound represented by the general formula (1) are shown below, but are not limited to these exemplified compounds.

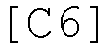

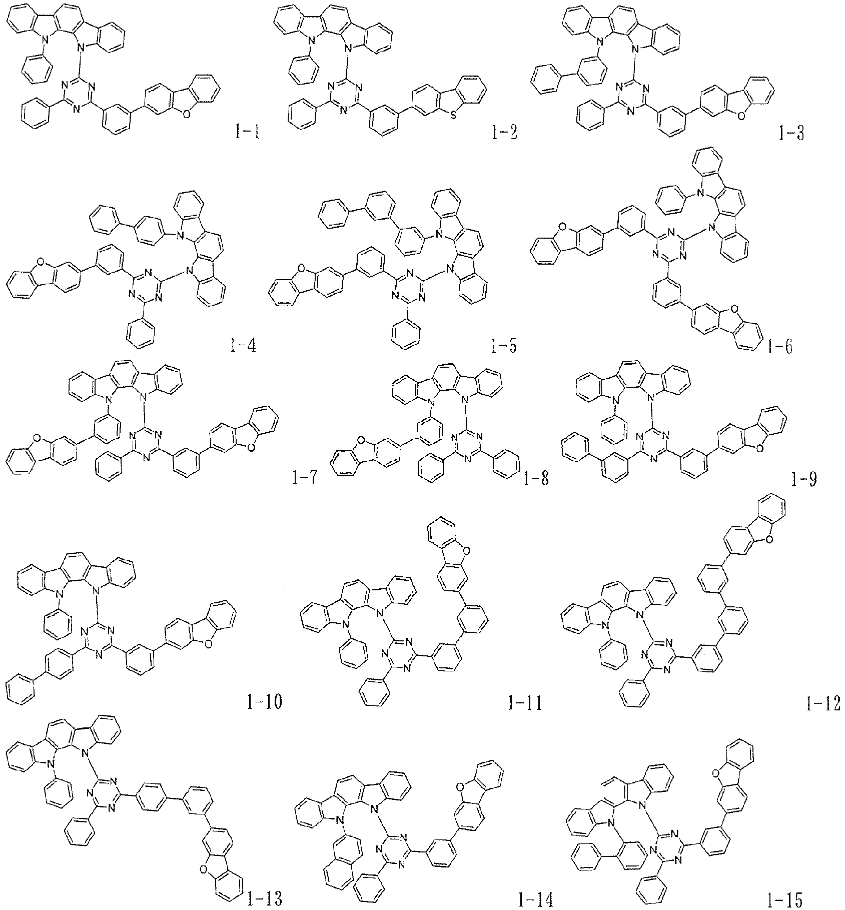

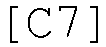

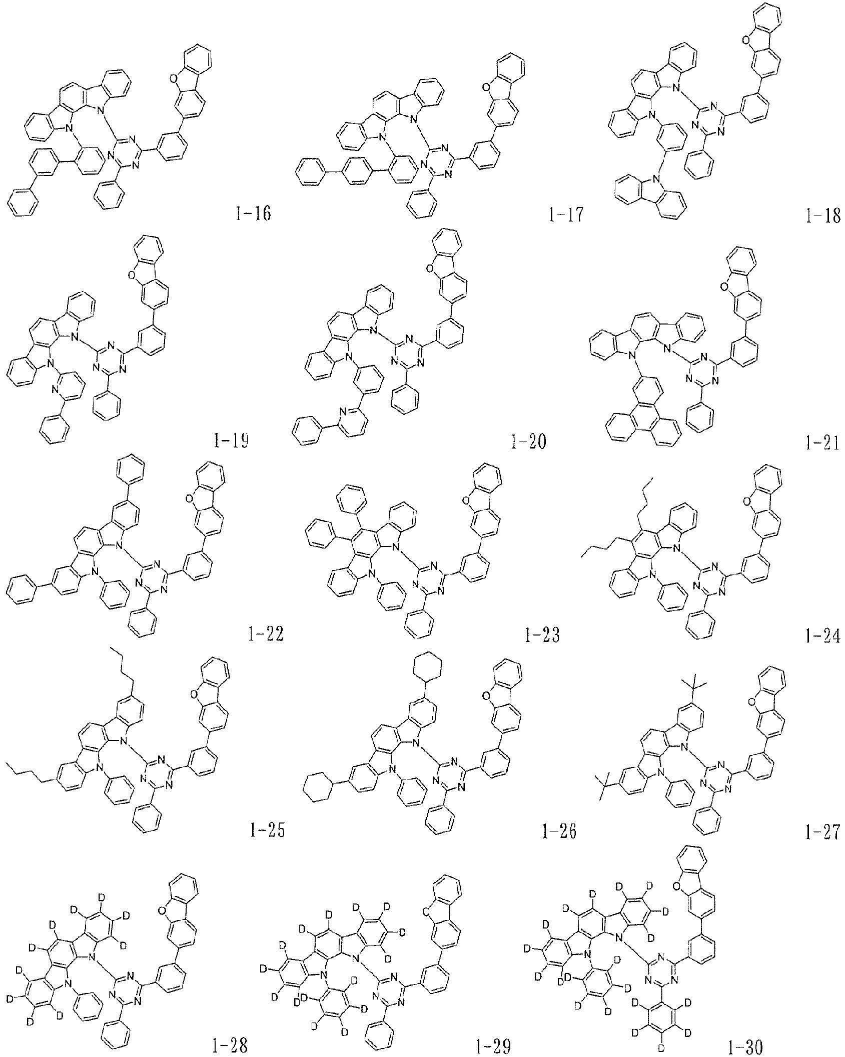

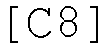

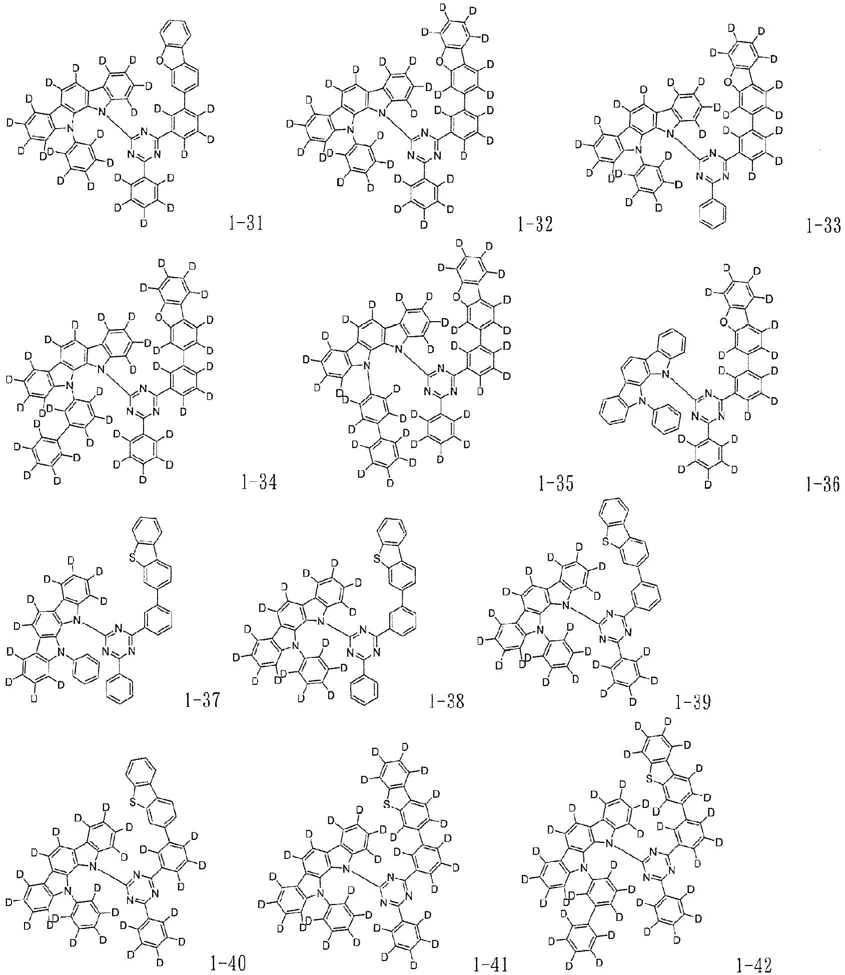

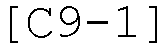

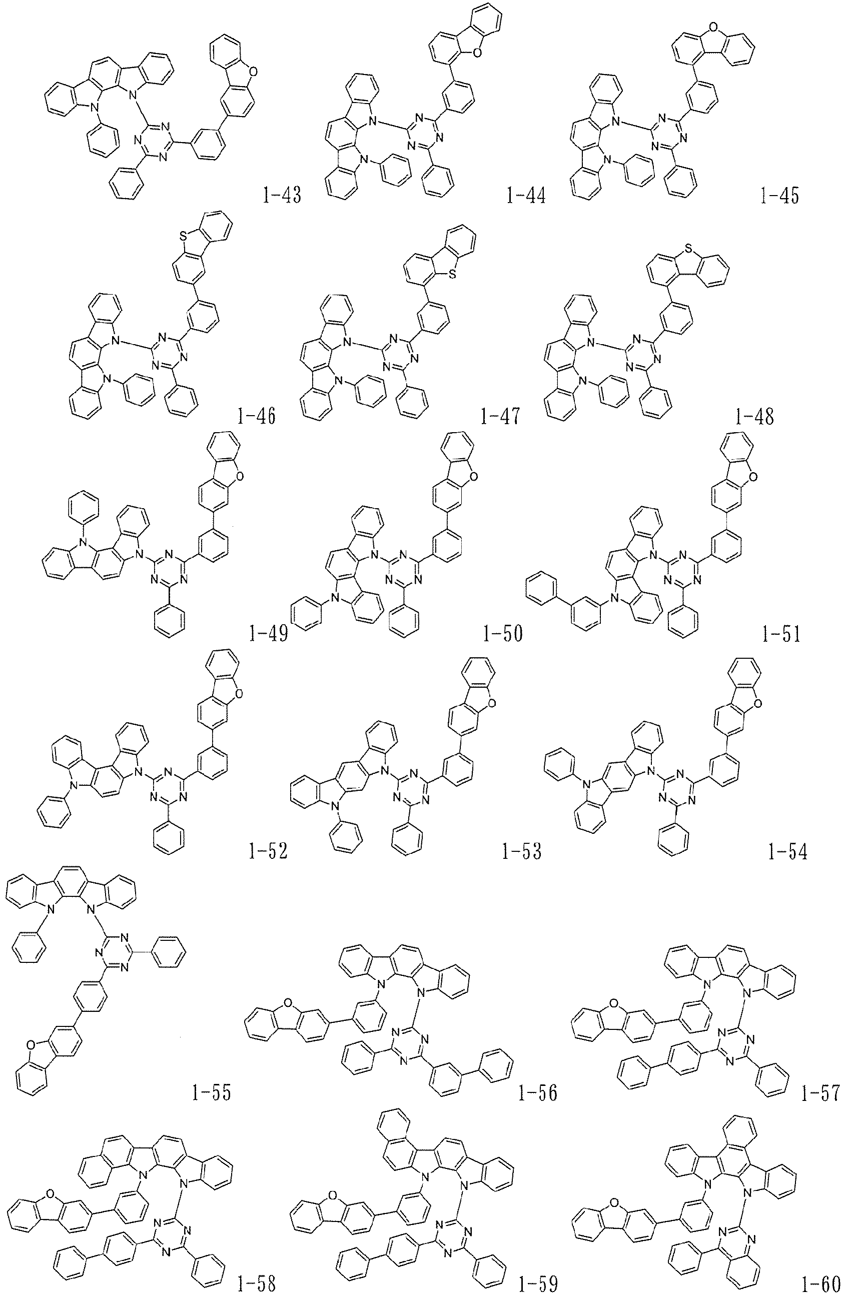

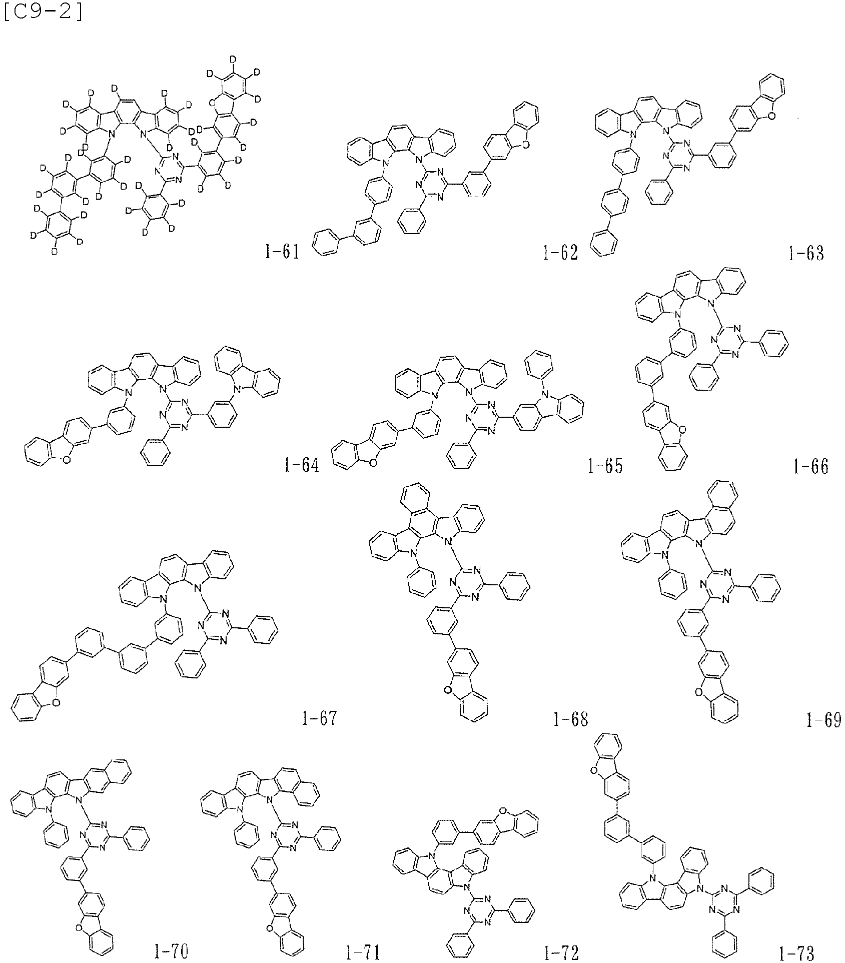

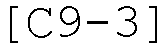

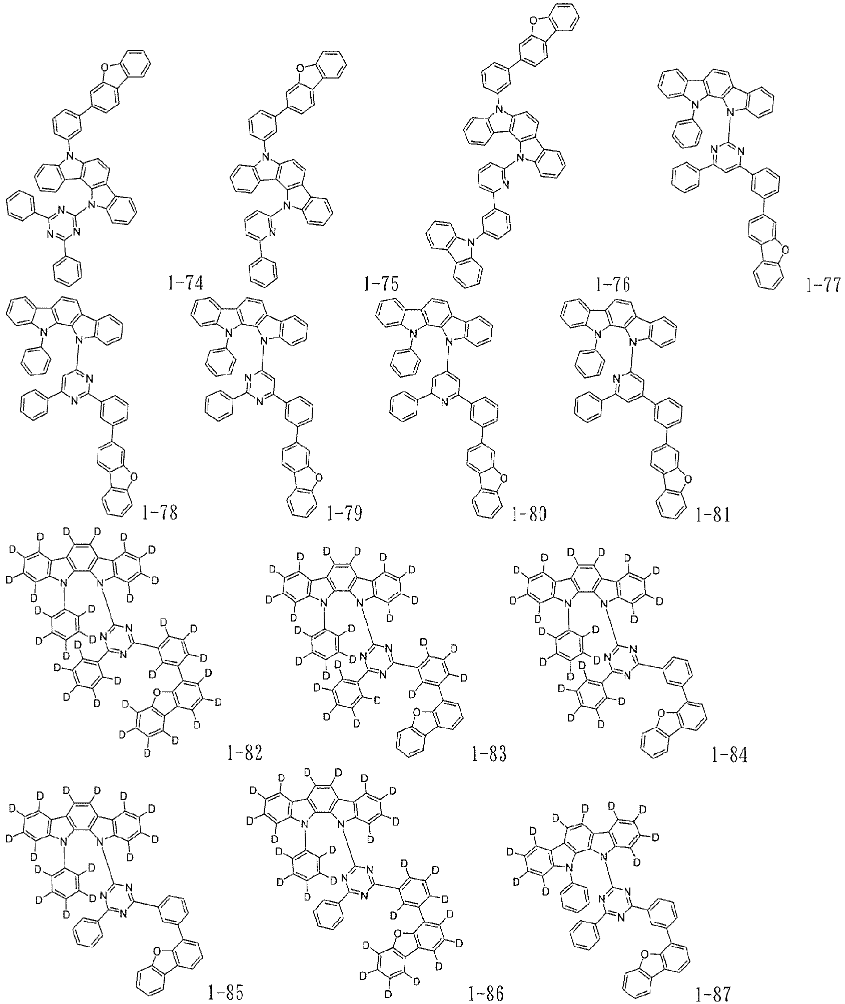

Specific examples of the compound represented by the general formula (2) are shown below, but are not limited to these exemplified compounds.

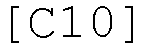

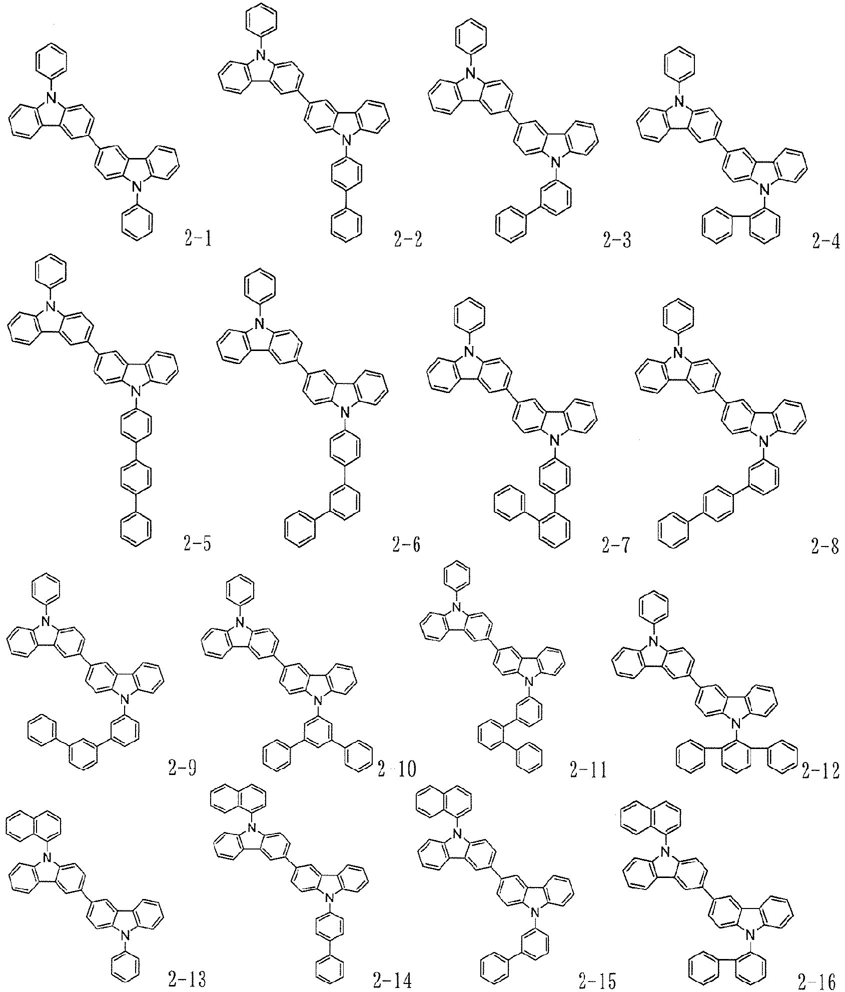

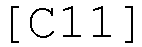

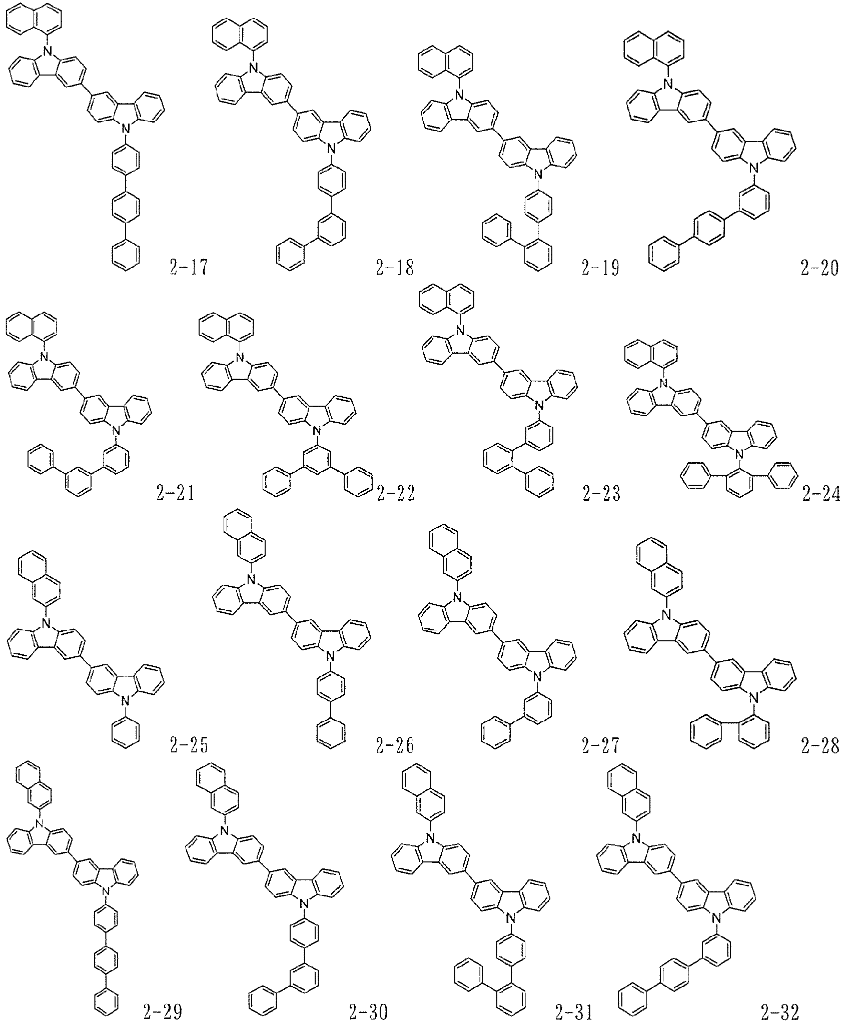

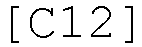

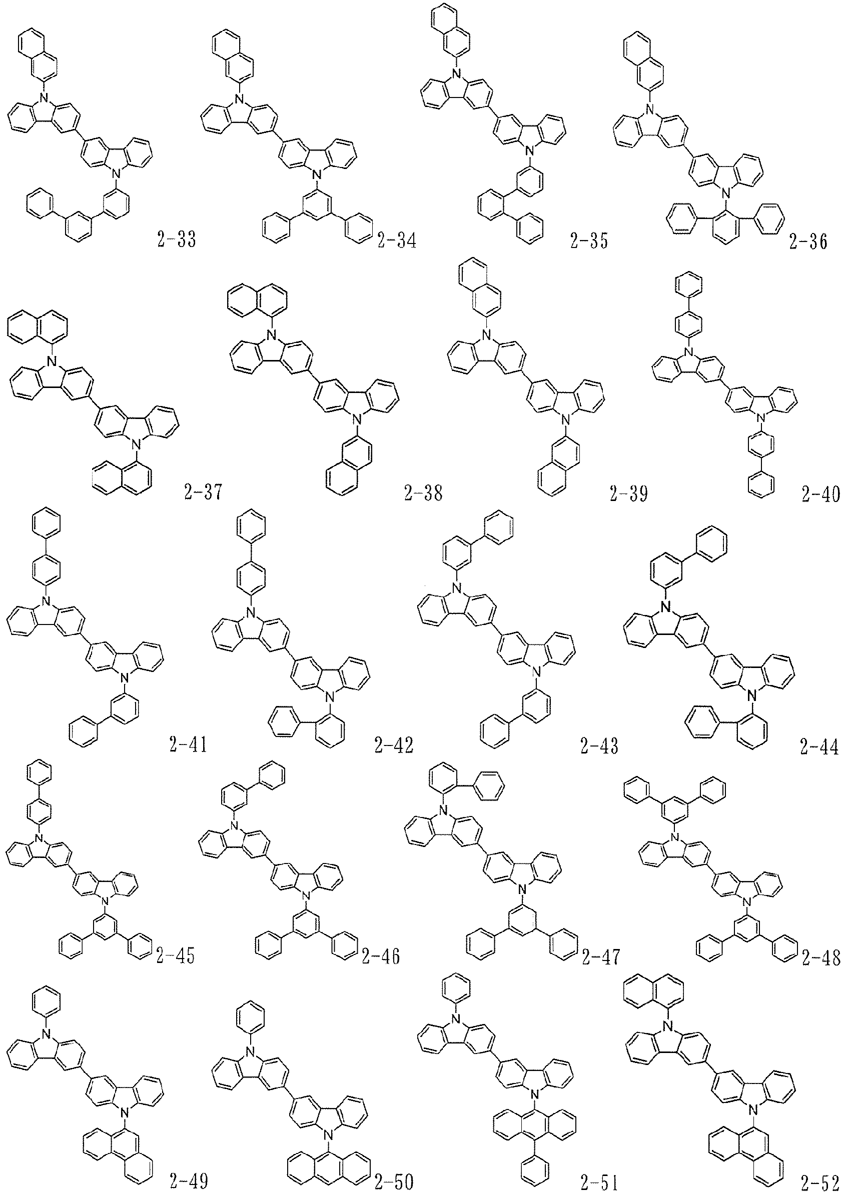

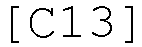

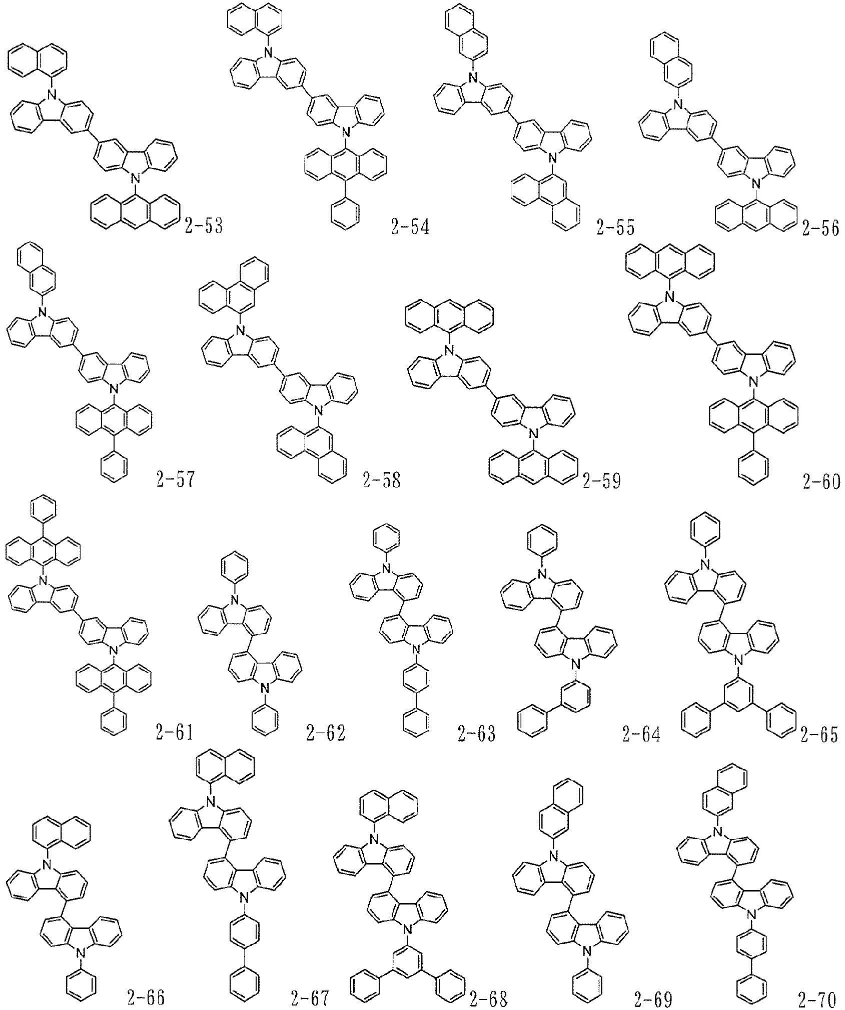

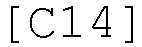

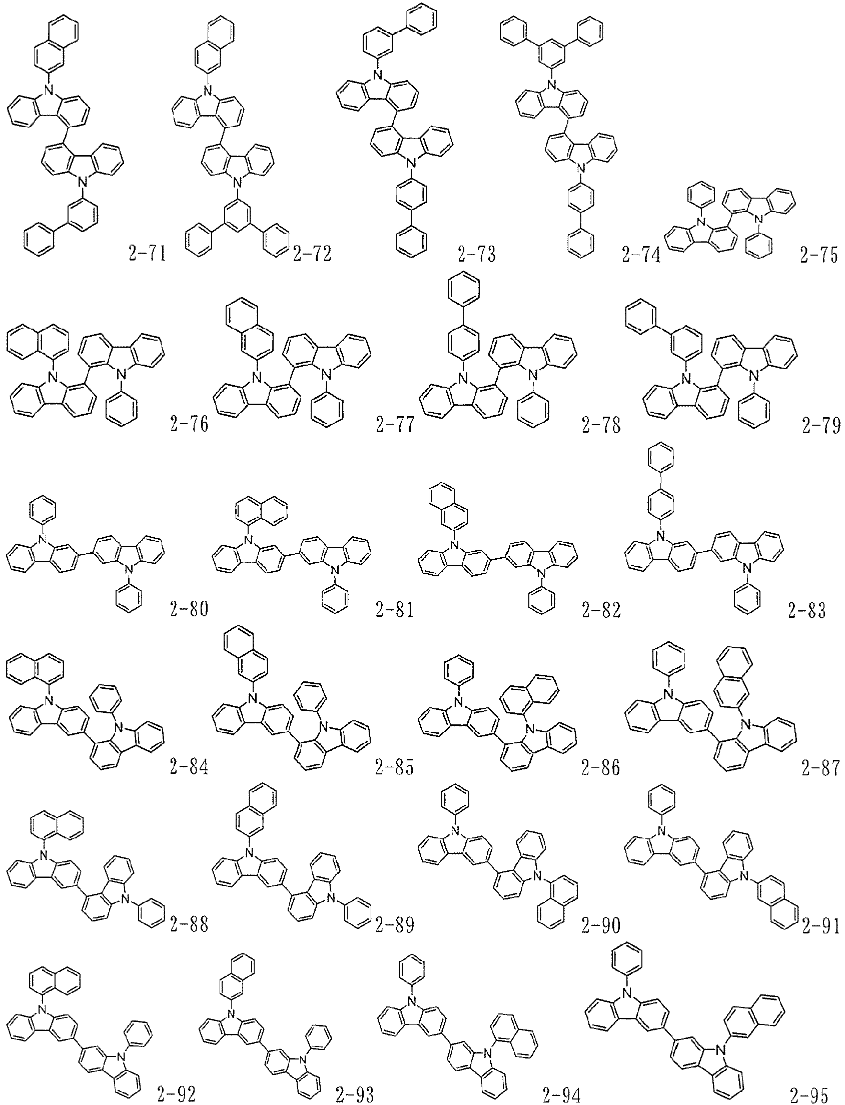

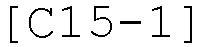

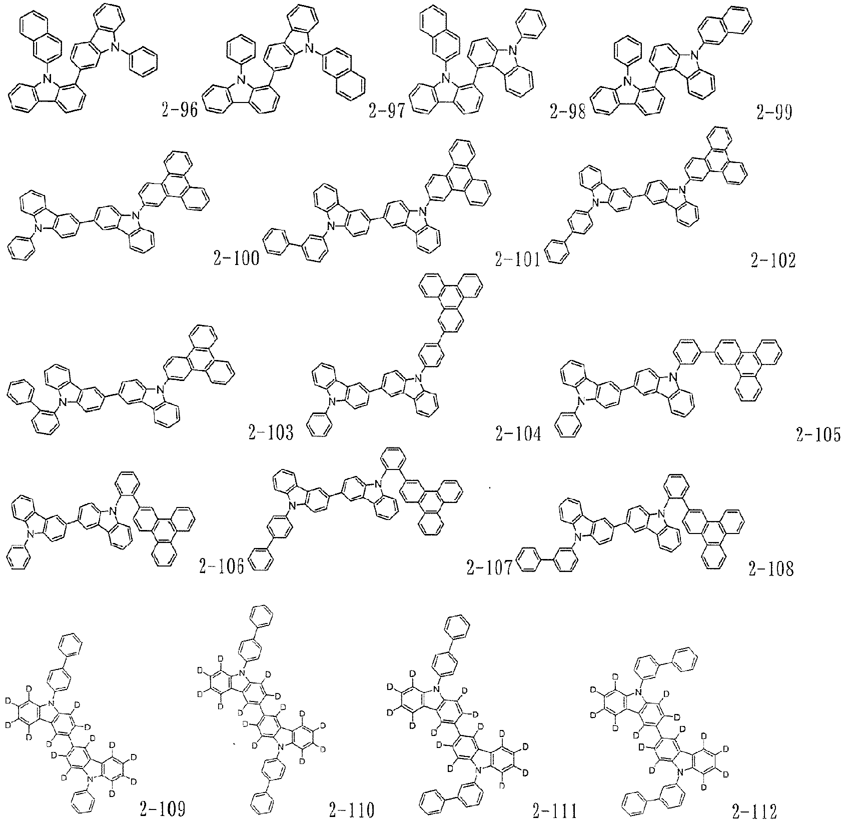

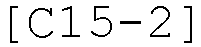

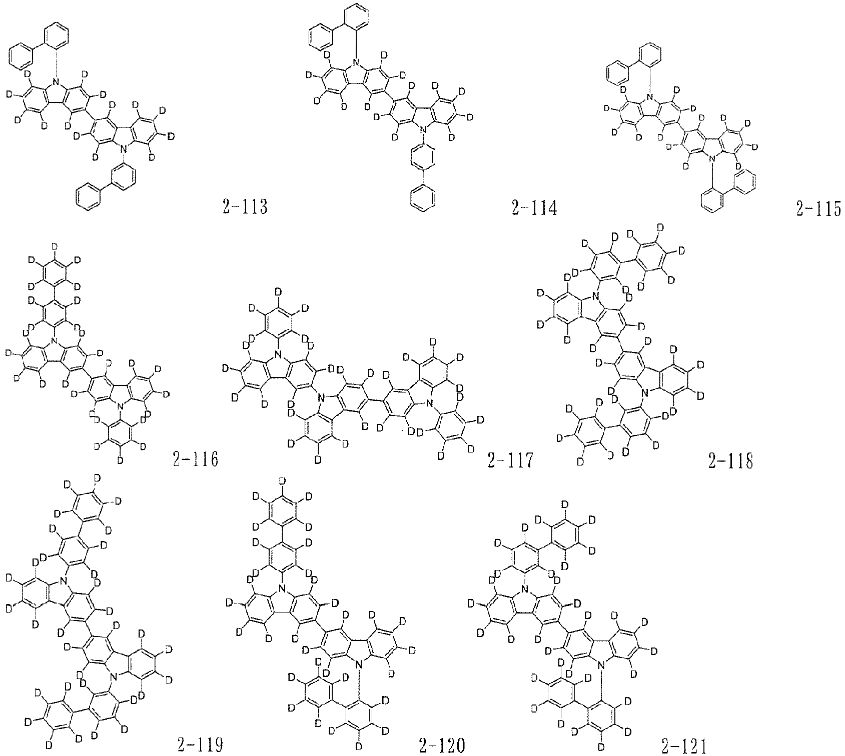

The host material for an organic EL device of the present invention is suitably used as a host material of a light-emitting layer.

Next, the structure of the organic EL device of the present invention will be described by referring to the drawing, but the structure of the organic EL device of the present invention is not limited thereto.

Figure 1 is a cross-sectional view showing a structure example of an organic EL device generally used for the present invention, in which there are indicated a substrate 1, an anode 2, a hole injection layer 3, a hole transport layer 4, a light-emitting layer 5, an electron transport layer 6, and a cathode 7. The organic EL device of the present invention may have an exciton blocking layer adjacent to the light-emitting layer and may have an electron blocking layer between the light-emitting layer and the hole injection layer. The exciton blocking layer can be inserted into either of the anode side, and the cathode side of the light-emitting layer and inserted into both sides at the same time. The organic EL device of the present invention has the anode, the light-emitting layer, and the cathode as essential layers, and preferably has a hole injection transport layer and an electron injection transport layer in addition to the essential layers, and further preferably has a hole blocking layer between the light-emitting layer and the electron injection transport layer. Note that the hole injection transport layer refers to either or both of a hole injection layer and a hole transport layer, and the electron injection transport layer refers to either or both of an electron injection layer and an electron transport layer.

A structure reverse to that of Figure 1 is applicable, in which a cathode 7, an electron transport layer 6, a light-emitting layer 5, a hole transport layer 4, a hole injection layer 3, and an anode 2 are laminated on a substrate 1 in this order. In this case, layers may be added or omitted as necessary.

### - Substrate -

The organic EL device of the present invention is preferably supported on a substrate. The substrate is not particularly limited, and those conventionally used in organic EL devices may be used, and substrates made of, for example, glass, a transparent plastic, or quartz may be used.

### - Anode -

Regarding an anode material for an organic EL device, it is preferable to use a material of a metal, an alloy, an electrically conductive compound, and a mixture thereof, each having a large work function (4 eV or more). Specific examples of such an electrode material include a metal such as Au, and a conductive transparent material such as CuI, indium tin oxide (ITO), SnO₂, and ZnO. In addition, an amorphous material such as IDIXO (In₂O₃-ZnO), which is capable of forming a transparent conductive film, may be used. Regarding the anode, such an electrode material is used to form a thin film by, for example, a vapor-deposition or sputtering method, and a desired shape pattern may be formed by a photolithographic method; or if the pattern accuracy is not particularly required (about 100 µm or more), a pattern may be formed via a desired shape mask when the electrode material is vapor-deposited or sputtered. Alternatively, when a coatable substance such as an organic conductive compound is used, a wet film formation method such as a printing method or a coating method may be used. For taking emitted light from the anode, it is desired to have a transmittance of more than 10%, and the sheet resistance for the anode is preferably several hundreds Ω/□ or less. The film thickness is selected usually within 10 to 1000 nm, preferably within 10 to 200 nm though depending on the material.

### - Cathode -

Meanwhile, regarding a cathode material, a material of a metal (an electron injection metal), an alloy, an electrically conductive compound, or a mixture thereof, each having a small work function (4 eV or less) is used. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare earth metal. Among these, from the viewpoint of the electron injectability and the durability against oxidation and the like, a mixture of an electron injection metal and a second metal which is a stable metal having a larger work function value is suitable, and examples thereof include a magnesium/silver mixture, a magnesium/aluminum mixture, a magnesium/indium mixture, an aluminum/aluminum oxide mixture, a lithium/aluminum mixture and aluminum. The cathode can be produced by forming a thin film by a method such as vapor-depositing or sputtering of such a cathode material. In addition, the sheet resistance of cathode is preferably several hundreds Ω/□ or less. The film thickness is selected usually within 10 nm to 5 µm, preferably within 50 to 200 nm. Note that for transmission of emitted light, if either one of the anode and cathode of the organic EL device is transparent or translucent, emission luminance is improved, which is convenient.

In addition, formation of a film of the above metal with a thickness of 1 to 20 nm, on the cathode, followed by formation of a conductive transparent material described in the description on the anode thereon, enables production of a transparent or translucent cathode, and application of this enables production of a device wherein an anode and a cathode both have transmittance.

### - Light-emitting layer -

The light-emitting layer is a layer that emits light after excitons are generated when holes and electrons injected from the anode and the cathode, respectively, are recombined. As a light-emitting layer, an organic light-emitting dopant material and a host material may be contained.

As a host, a host material represented by any of the general formulas (1), (6) to (9) (also referred to as the host material of the present invention.) is used.

As the host material of the present invention, one kind thereof may be used, or two or more kinds of different compounds may be used, or one, or two or more other host materials such as known host materials may be used in combination. As other host material, a compound is preferable, which has hole transport ability and electron transport ability, which prevents elongation of the wavelength of light emitted, and which also has a high glass transition temperature.

When the host material of the present invention is contained as the first host material, the compound represented by any of the general formulas (2), (10) is particularly preferably used as the second host material, or other host material shown below may also be used as the second host material. When the host material of the present invention is used as the first host material and the compound represented by any of the general formulas (2), (10) is used as the second host material, other host material may also be used as a third host material.

Such other host material is one known in many Patent Literatures and the like, and can be selected therefrom. Specific examples of the host material include, but not particularly limited thereto, indolocarbazole derivatives described in WO2008/056746A1 or WO2008/146839A1, carbazole derivatives described in WO2009/086028A1 or WO2012/077520A1, CBP (N,N-biscarbazolylbiphenyl) derivatives, triazine derivatives described in WO2014/185595A1 or WO2018/021663A1, indenocarbazole derivatives described in WO2010/136109A1 or WO2011/000455A1, dibenzofuran derivatives described in WO2015/169412A1, triazole derivatives, indole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tert-amine compounds, styrylamine compounds, aromatic dimethylidene-based compounds, porphyrin-based compounds, anthraquinodimethane derivatives, anthrone derivatives, diphenylquinone derivatives, thiopyran dioxide derivatives, heterocyclic tetracarboxylic anhydrides of naphthalene, perylene, or the like, various metal complexes typified by phthalocyanine derivatives, metal complexes of 8-quinolinol derivatives, metal phthalocyanine, and metal complexes of benzoxazole or benzothiazole derivatives, and polymer compounds such as polysilane-based compounds, poly(N-vinylcarbazole) derivatives, aniline-based copolymers, thiophene oligomers, polythiophene derivatives, polyphenylene derivatives, polyphenylene vinylene derivatives, and polyfluorene derivatives.

Specific examples of other host material described above are shown below, but are not limited thereto.

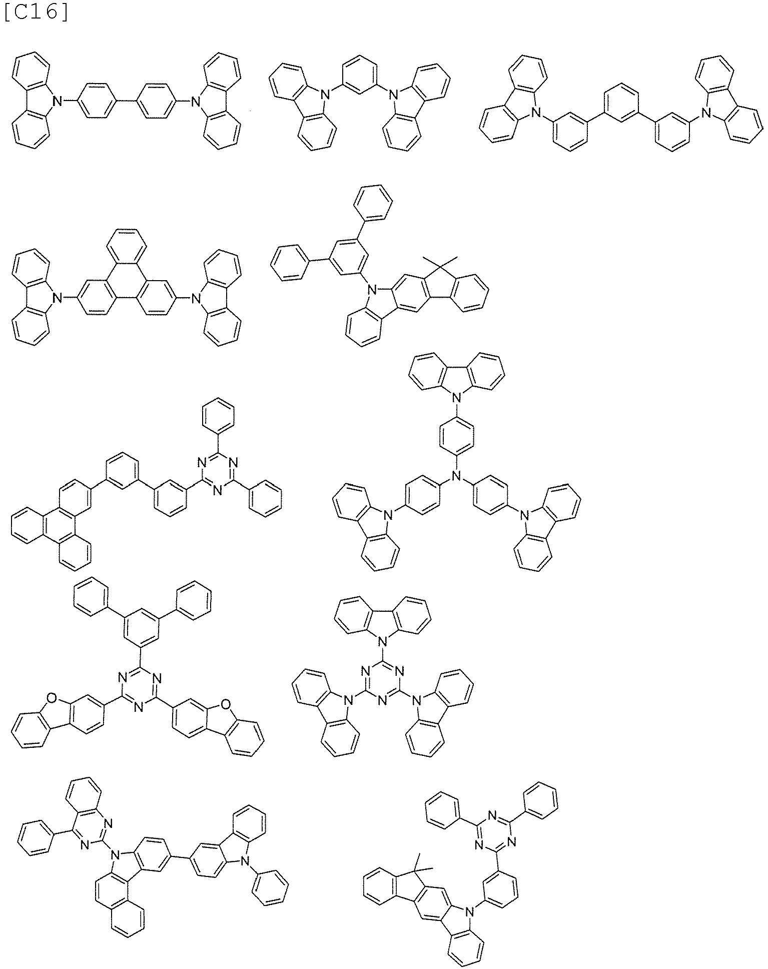

Preferred examples of the organic light-emitting dopant material include a phosphorescent dopant, a fluorescence-emitting dopant or a thermally activated delayed fluorescence-emitting dopant.

Preferred is a phosphorescent dopant including an organic metal complex containing at least one metal selected from ruthenium, rhodium, palladium, silver, rhenium, osmium, iridium, platinum and gold. Specifically, iridium complexes described in J. Am. Chem. Soc. 2001, 123, 4304, JP2013-530515A, US2016/0049599A1, US2017/0069848A1, US2018/0282356A1, US2019/0036043A1, and the like, or platinum complexes described in US2018/0013078A1, KR2018/094482A, and the like are preferably used, but the phosphorescent dopant material is not limited thereto.

Regarding the phosphorescent dopant material, only one kind thereof may be contained in the light-emitting layer, or two or more kinds thereof may be contained. A content of the phosphorescent dopant material is preferably 0.1 to 30 wt% and more preferably 1 to 20 wt% with respect to the host material.

The phosphorescent dopant material is not particularly limited, and specific examples thereof include the following.

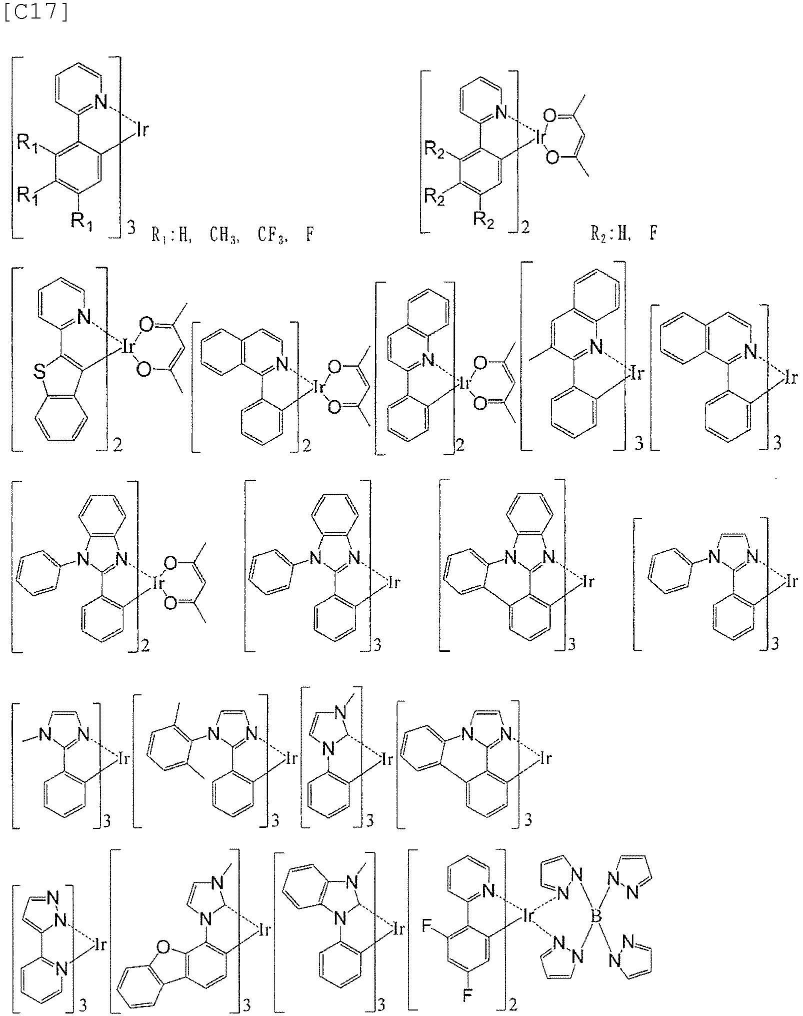

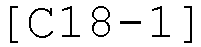

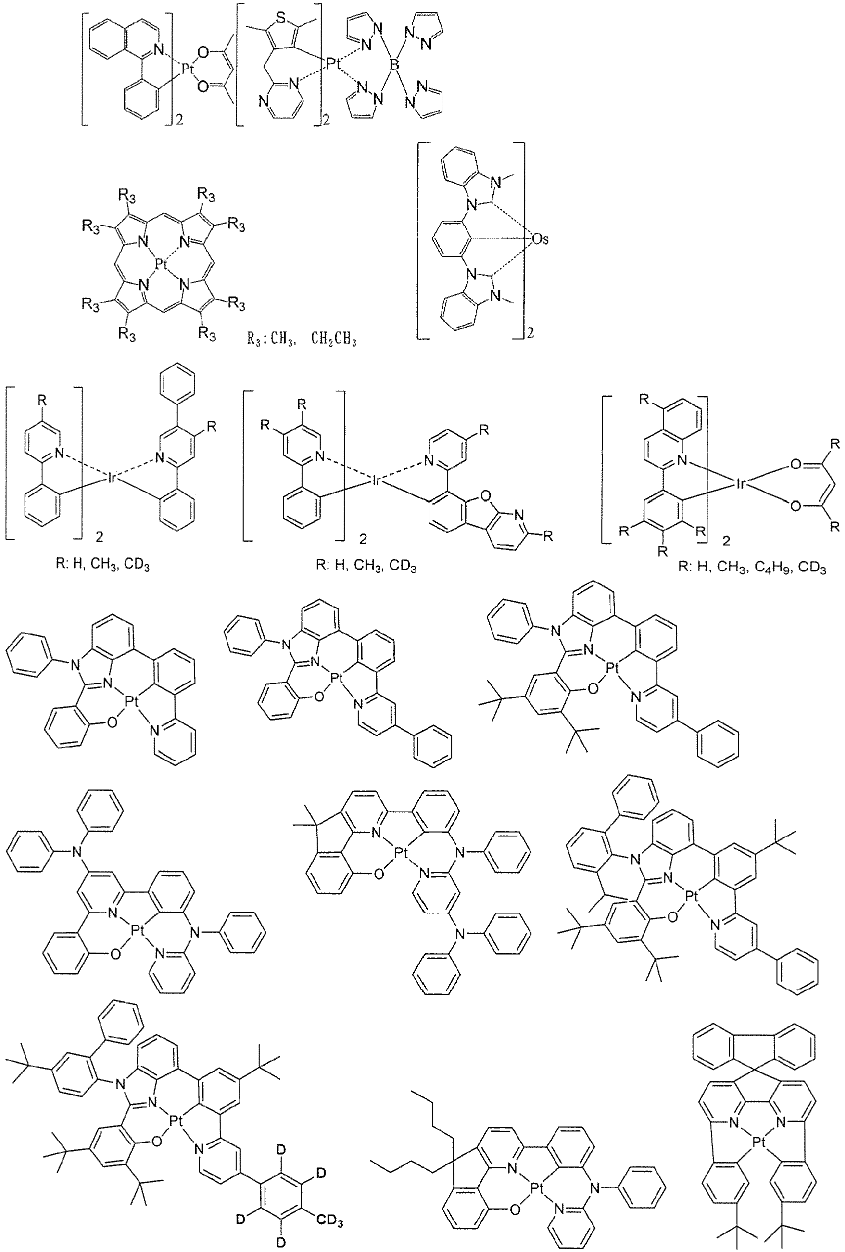

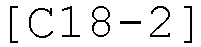

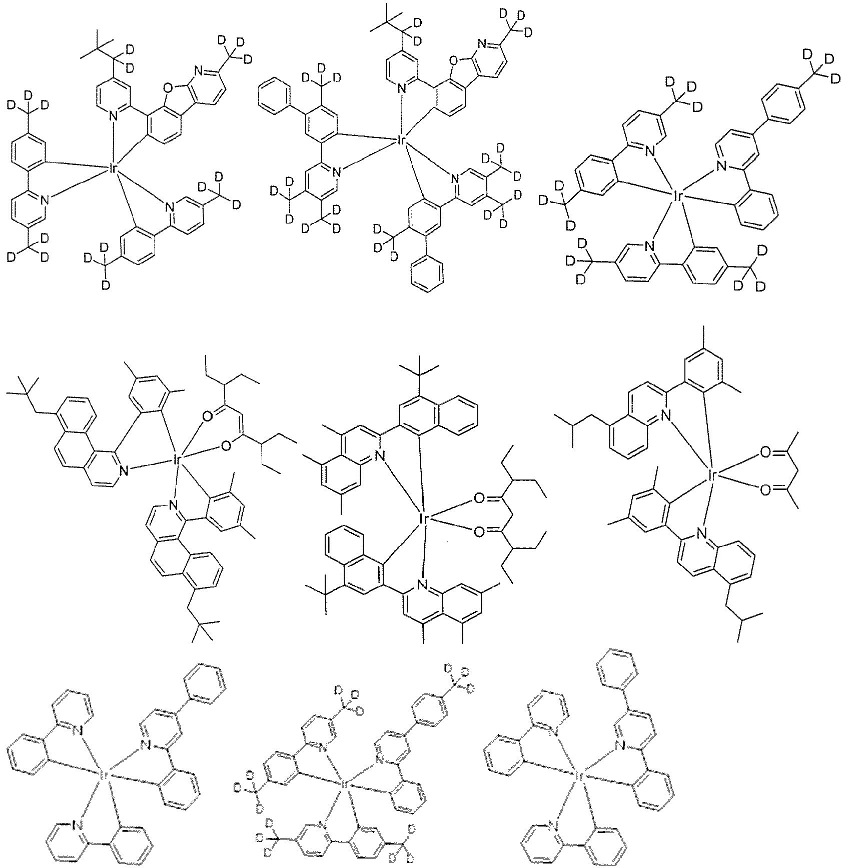

The fluorescence-emitting dopant is not particularly limited. Examples thereof include benzoxazole derivatives, benzothiazole derivatives, benzimidazole derivatives, styrylbenzene derivatives, polyphenyl derivatives, diphenylbutadiene derivatives, tetraphenyl butadiene derivatives, naphthalimido derivatives, coumarin derivatives, fused aromatic compounds, perinone derivatives, oxadiazole derivatives, oxazine derivatives, aldazine derivatives, pyrrolidine derivatives, cyclopentadiene derivatives, bisstyryl anthracene derivatives, quinacridone derivatives, pyrrolopyridine derivatives, thiadiazolopyridine derivatives, styrylamine derivatives, diketopyrrolopyrrole derivatives, aromatic dimethylidine compounds, metal complexes of 8-quinolinol derivatives or metal complexes of pyromethene derivatives, rare earth complexes, various metal complexes represented by transition metal complexes, polymer compounds such as polythiophene, polyphenylene, and polyphenylene vinylene, and organosilane derivatives. Preferred examples thereof include fused aromatic derivatives, styryl derivatives, diketopyrrolopyrrole derivatives, oxazine derivatives, pyromethene metal complexes, transition metal complexes, and lanthanoid complexes. More preferable examples thereof include naphthalene, pyrene, chrysene, triphenylene, benzo[c]phenanthrene, benzo[a]anthracene, pentacene, perylene, fluoranthene, acenaphthofluoranthene, dibenzo[a,j]anthracene, dibenzo[a,h]anthracene, benzo[a]naphthalene, hexacene, naphtho[2,1-f]isoquinoline, α-naphthaphenanthridine, phenanthrooxazole, quinolino[6,5-f]quinoline, and benzothiophanthrene. These may have an alkyl group, an aryl group, an aromatic heterocyclic group, or a diarylamino group as a substituent.

Regarding the fluorescence-emitting dopant material, only one kind thereof may be contained in the light-emitting layer, or two or more kinds thereof may be contained. A content of the fluorescence-emitting dopant material is preferably 0.1 to 20 wt% and more preferably 1 to 10 wt% with respect to the host material.

The thermally activated delayed fluorescence-emitting dopant is not particularly limited. Examples thereof include: metal complexes such as a tin complex and a copper complex; indolocarbazole derivatives described in WO2011/070963A1; cyanobenzene derivatives and carbazole derivatives described in Nature 2012, 492, 234; and phenazine derivatives, oxadiazole derivatives, triazole derivatives, sulfone derivatives, phenoxazine derivatives, and acridine derivatives described in Nature Photonics 2014, 8,326.

The thermally activated delayed fluorescence-emitting dopant material is not particularly limited, and specific examples thereof include the following.

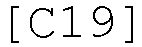

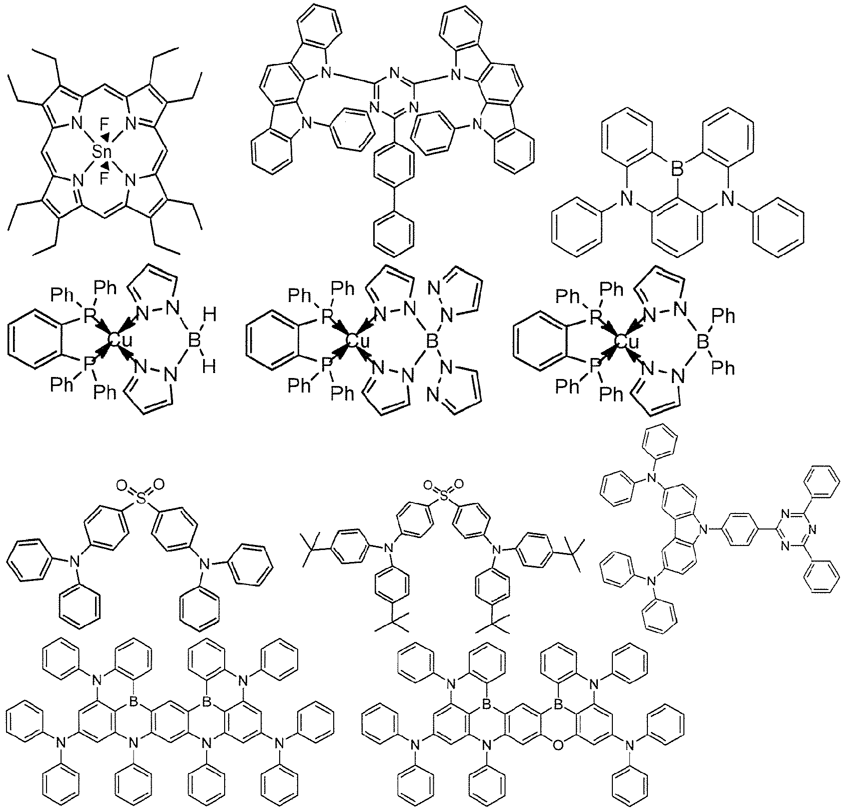

Regarding the thermally activated delayed fluorescence-emitting dopant material, only one kind thereof may be contained in the light-emitting layer, or two or more kinds thereof may be contained. In addition, the thermally activated delayed fluorescence-emitting dopant may be used by mixing with a phosphorescent dopant and a fluorescence-emitting dopant. A content of the thermally activated delayed fluorescence-emitting dopant material is preferably 0.1% to 50wt% and more preferably 1% to 30wt% with respect to the host material.

### - Injection Layer -

The injection layer is a layer that is provided between an electrode and an organic layer in order to lower a driving voltage and improve emission luminance, and includes a hole injection layer and an electron injection layer, and may be present between the anode and the light-emitting layer or the hole transport layer, and between the cathode and the light-emitting layer or the electron transport layer. The injection layer can be provided as necessary.

### - Hole Blocking Layer -

The hole blocking layer has a function of the electron transport layer in a broad sense, and is made of a hole blocking material having a function of transporting electrons and a significantly low ability to transport holes, and can block holes while transporting electrons, thereby improving a probability of recombining electrons and holes in the light-emitting layer.

### - Electron Blocking Layer -

The electron blocking layer has a function of a hole transport layer in a broad sense and blocks electrons while transporting holes, thereby enabling a probability of recombining electrons and holes in the light-emitting layer to be improved.

Regarding the material of the electron blocking layer, a known electron blocking layer material can be used and a material of the hole transport layer to be described below can be used as necessary. A film thickness of the electron blocking layer is preferably 3 to 100 nm, and more preferably 5 to 30 nm.

### - Exciton Blocking Layer -

The exciton blocking layer is a layer for preventing excitons generated by recombination of holes and electrons in the light-emitting layer from being diffused in a charge transport layer, and insertion of this layer allows excitons to be efficiently confined in the light-emitting layer, enabling the luminous efficiency of the device to be improved. The exciton blocking layer can be inserted, in a device having two or more light-emitting layers adjacent to each other, between two adjacent light-emitting layers.

Regarding the material of the exciton blocking layer, a known exciton blocking layer material can be used. Examples thereof include 1,3-dicarbazolyl benzene (mCP) and bis(2-methyl-8-quinolinolato)-4-phenylphenolato aluminum (III) (BAlq).

### - Hole Transport Layer -

The hole transport layer is made of a hole transport material having a function of transporting holes, and the hole transport layer can be provided as a single layer or a plurality of layers.

The hole transport material has either hole injection, transport properties or electron barrier properties, and may be an organic material or an inorganic material. For the hole transport layer, any one selected from conventionally known compounds can be used. Examples of such a hole transport material include porphyrin derivatives, arylamine derivatives, triazole derivatives, oxadiazole derivatives, imidazole derivatives, polyarylalkane derivatives, pyrazoline derivatives and pyrazolone derivatives, phenylenediamine derivatives, arylamine derivatives, amino-substituted chalcone derivatives, oxazole derivatives, styryl anthracene derivatives, fluorenone derivatives, hydrazone derivatives, stilbene derivatives, silazane derivatives, an aniline copolymer, and a conductive polymer oligomer, and particularly a thiophene oligomer. Use of porphyrin derivatives, arylamine derivatives, or styrylamine derivatives is preferred. Use of arylamine derivatives is more preferred.

### - Electron Transport Layer -

The electron transport layer is made of a material having a function of transporting electrons, and the electron transport layer can be provided as a single layer or a plurality of layers.

The electron transport material (which may also serve as a hole blocking material) may have a function of transferring electrons injected from the cathode to the light-emitting layer. For the electron transport layer, any one selected from conventionally known compounds can be used, and examples thereof include polycyclic aromatic derivatives such as naphthalene, anthracene, and phenanthroline, tris(8-quinolinolato)aluminum(III) derivatives, phosphine oxide derivatives, nitro-substituted fluorene derivatives, diphenylquinone derivatives, thiopyran dioxide derivatives, carbodiimide, fluorenylidene methane derivatives, anthraquinodimethane derivatives and anthrone derivatives, bipyridine derivatives, quinoline derivatives, oxadiazole derivatives, benzimidazole derivatives, benzothiazole derivatives, and indolocarbazole derivatives. In addition, a polymer material in which the above material is introduced into a polymer chain or the above material is used for a main chain of a polymer can be used.

The method for producing the organic EL device of the present invention comprises a step of mixing the first host material and the second host material in advance, and a step of vapor-depositing the resulting mixture from one vapor deposition source to form a light-emitting layer. Thus, two host materials can be mixed in advance, resulting in an enhancement in performance of an organic EL device. The mixing method here adopted can be powder mixing or melting and mixing.

A difference in temperature at 50% weight loss of the first host material and the second host material in the composition obtained by mixing in advance is preferably within 20°C. The 50% weight reduction temperature is a temperature at which the weight is reduced by 50% when the temperature is raised from room temperature to 550°C at a rate of 10°C/ min in TG-DTA measurement under a nitrogen stream reduced pressure (1 Pa). It is considered that vaporization due to evaporation or sublimation the most vigorously occurs around this temperature.

### Examples

Hereafter, the present invention will be described in more detail by referring to Examples, but the present invention is not limited to these Examples and can be implemented in various forms without departing from the gist thereof.

Synthesis Examples of compound 1-1, compound 1-3, compound 1-8, compound 1-13, compound 1-29, compound 1-44, compound 1-55, and compound 1-57 are shown as representative examples. Other compounds were also synthesized by similar methods. Rates of deuteration were determined by proton nuclear magnetic resonance spectroscopy.

### Synthesis Example 1

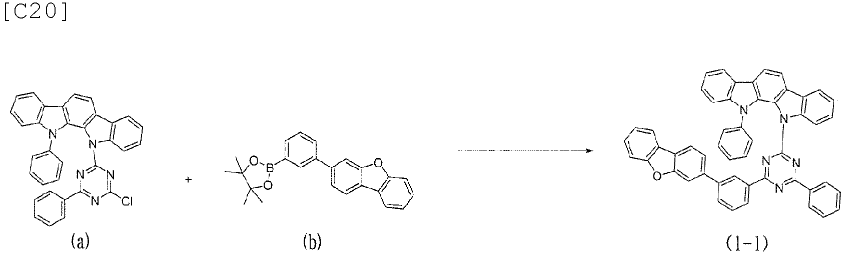

To 7.0 g (13.4 mmol) of compound (a) were added 5.0 g (13.5 mmol) of compound (b), 0.12 g (0.21 mmol) of CX21, 3.2 g (30.2 mmol) of sodium carbonate, 250 mL of toluene, 100 mL of ethanol, and 20 mL of water, and the mixture was stirred under a nitrogen atmosphere at 75°C for 2 hours. The mixture was cooled to room temperature, and then 50 mL of water was added, thereafter extraction was performed with toluene as an organic phase, and the organic phase was dried over MgSO₄, and concentrated to dryness to give 10.7 g of a yellow solid. The resulting solid was purified by silica gel column chromatography and crystallization to give 3.5 g (4.80 mmol, yield 36%) of compound (1-1) as a yellow solid (APCI-TOFMS, m/z 730 [M+H]⁺).

### Synthesis Example 2

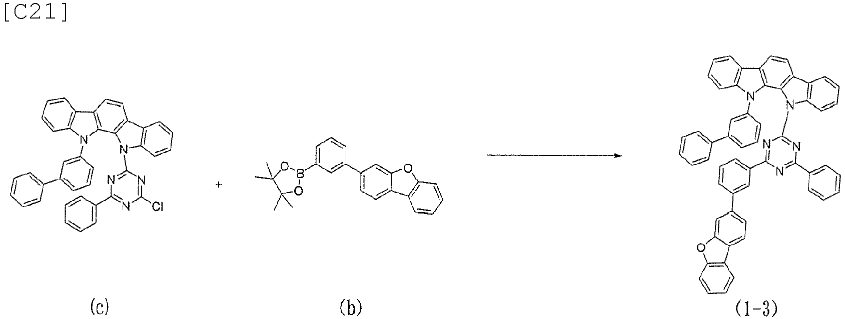

To 5.9 g (9.86 mmol) of compound (c) were added 3.6 g (9.72 mmol) of compound (b), 2.3 g (21.7 mmol) of sodium carbonate, 80 mg (0.14 mmol) of CX21, 80 g of m-xylene, 40 g of ethanol, and 8.0 g of water, and the mixture was stirred under a nitrogen atmosphere at 110°C for 2.5 hours. The mixture was cooled to room temperature, then 50 mL of water was added, and thereafter extraction was performed with toluene as an organic phase, which was dried over MgSO₄, and concentrated to dryness to give 7.7 g of a yellow solid. The mixture was purified by silica gel column chromatography to give 5.4 g (6.70 mmol, yield 68%) of compound (1-3) as a yellow solid (APCI-TOFMS, m/z 806 [M+H]⁺).

### Synthesis Example 3

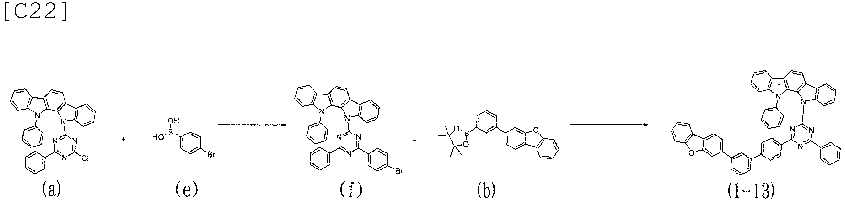

To 39.0 g (75 mmol) of compound (a) were added 15 g (75 mmol) of compound (e), 4.3 g (3.75 mmol) of tetrakistriphenylphosphine palladium(0), 48.8 g (150 mmol) of cesium carbonate, and 500 mL of 1,4-dioxane, and the mixture was stirred under a nitrogen atmosphere at 110°C for 4 hours. The mixture was cooled to room temperature, then the reaction liquid was added to 1 L of water, and the resulting yellow solid was purified by silica gel column chromatography to give 15.2 g (24 mmol, yield 32%) of intermediate (f) as a yellow solid. Next, 2.5 g (6.75 mmol) of compound (b), 57.9 mg (0.10 mmol) of Cx21, 1.8 g (13.5 mmol) of potassium carbonate, 18.7 g of water, and 145 g of m-xylene were added to 4.3 g (6.75 mmol) of obtained intermediate (f), and the mixture was stirred under a nitrogen atmosphere at 110°C overnight. The mixture was cooled to room temperature, then 50 mL of water was added, and thereafter extraction was performed with toluene as an organic phase, which was dried over MgSO₄, and concentrated to dryness to give 2.7 g of a yellow solid. This was purified by silica gel column chromatography to give 1.2 g (1.49 mmol, yield 22%) of compound (1-13) as a yellow solid (APCI-TOFMS, m/z 806 [M+H]⁺).

### Synthesis Example 4

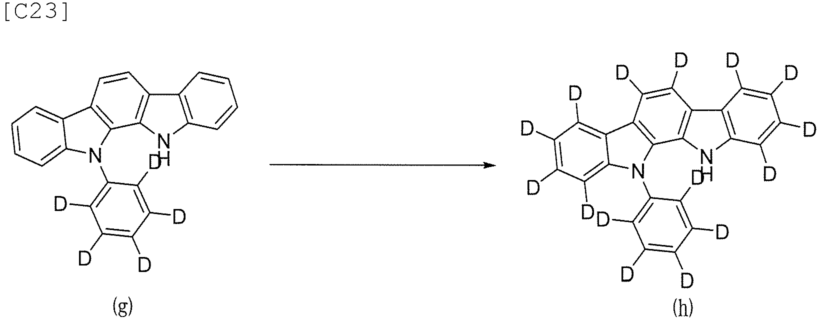

To 10.0 g (29.6 mmol) of compound (g) were added 100 mL of deuterated benzene (C₆D₆) and 30.0 g (200 mmol) of trifluoromethanesulfonic acid (TfOH), and the mixture was heated and stirred under a nitrogen atmosphere at 50°C for 3 hours. The reaction liquid was added to a solution of sodium carbonate (23.0 g) in deuterated water (200 mL), and the mixture was rapidly cooled, and subjected to separation and purification to give 8.7 g (25.0 mmol, yield 84%, rate of deuteration 93%) of compound (h) as a deuterated product.

### Synthesis Example 5

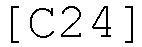

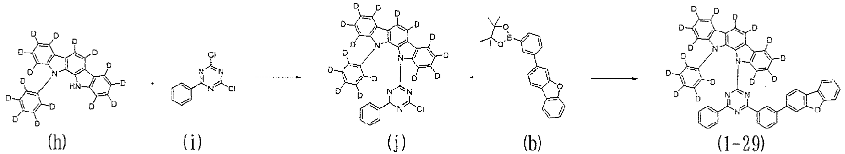

Under a nitrogen atmosphere, 0.8 g of 60 wt% sodium hydride was added to 100 mL of N,N'-dimethylacetamide to prepare a suspension. To this was added 5.0 g (14.4 mmol) of intermediate (h) dissolved in 160 mL of N,N'-dimethylacetamide, and the mixture was stirred for 30 minutes. To this was added 4.1 g (18.1 mmol) of compound (i), and then the mixture was stirred for 1 hour. The reaction solution was added to a solution mixed with distilled water (500 mL) while being stirred, and the resulting precipitated solid was collected by filtration. The resulting solid was purified by silica gel column chromatography and crystallization to give 3.9 g (7.26 mmol, yield 50%) of compound (j) as a yellow solid.

Next, 1.5 g (4.09 mmol) of compound (b), 31.9 mg (0.056 mmol) of Cx21, 1.0 g (7.44 mmol) of potassium carbonate, 10.3 g of water, and 80.0 g of m-xylene were added to 2.0 g (3.72 mmol) of obtained intermediate (j), and the mixture was stirred under a nitrogen atmosphere at 110°C overnight. The mixture was cooled to room temperature, then 50 mL of water was added, and thereafter extraction was performed with toluene as an organic phase, which was dried over MgSO₄, and concentrated to dryness to give 3.1 g of a yellow solid. This was purified by silica gel column chromatography to give 1.6 g (2.15 mmol, yield 58%, rate of deuteration 43%) of compound (1-29) as a yellow solid (APCI-TOFMS, m/z 745 [M+H]⁺).

### Synthesis Example 6

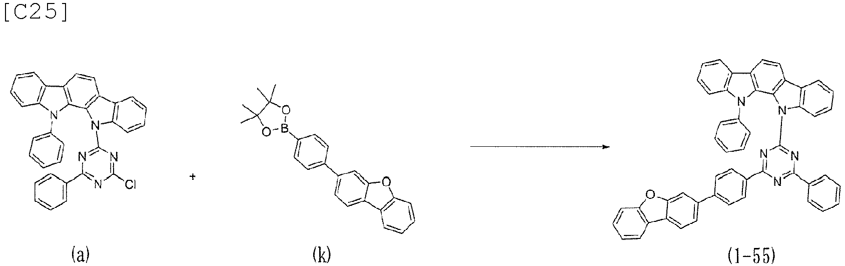

To 2.8 g (5.36 mmol) of compound (a) were added 2.0 g (5.40 mmol) of compound (k), 50 mg (0.087 mmol) of CX21, 1.3 g (12.3 mmol) of sodium carbonate, 100 mL of toluene, 40 mL of ethanol, and 10 mL of water, and the mixture was stirred under a nitrogen atmosphere at 75°C for 2 hours. The mixture was cooled to room temperature, then 20 mL of water was added, thereafter extraction was performed with toluene as an organic phase, and the organic phase was dried over MgSO₄, and concentrated to dryness to give 3.4 g of a yellow solid. The resulting solid was purified by silica gel column chromatography and crystallization to give 1.0 g (1.37 mmol, yield 26%) of compound (1-55) as a yellow solid (APCI-TOFMS, m/z 730 [M+H]⁺).

### Synthesis Example 7

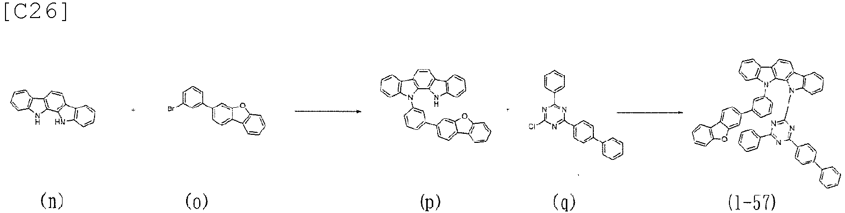

To 4.3 g (16.9 mmol) of compound (n) were added 6.0 g (18.6 mmol) of compound (o), 0.32 g (1.68 mmol) of cupper(I) iodide, 0.49 g (3.38 mmol) of 8-hydroxyquinoline, 4.7 g (34.0 mmol) of potassium carbonate, and 300 mL of 1,3-dimethyl-2-imidazolidinone, and the mixture was stirred under a nitrogen atmosphere at 140°C overnight. The mixture was cooled to room temperature, and then the reaction solution was added to a distilled water (500 mL) while being stirred, and the resulting precipitated solid was collected by filtration. The resulting solid was purified by silica gel column chromatography and crystallization to give 3.38 g (6.78 mmol, yield 40%) of intermediate (p) as a white solid.

Next, 0.24 g of 60 wt% sodium hydride was added to 40 ml of N,N'-dimethylacetamide under a nitrogen atmosphere to prepare a suspension. To this was added 2.0 g (4.01 mmol) of intermediate (p) dissolved in 100 mL of N,N'-dimethylacetamide, and the mixture was stirred for 30 minutes. To this was added 1.7 g (4.81 mmol) of compound (q), and then the mixture was stirred for 1 hour. The reaction solution was added to a solution of methanol (100 mL) mixed with distilled water (25 mL) while being stirred, and the resulting precipitated solid was collected by filtration. The resulting solid was purified by silica gel column chromatography and crystallization to give 0.97 g (1.20 mmol, yield 30%) of compound 1-57 as a yellow solid (APCI-TOFMS, m/z 806 [M+H]⁺).

### Synthesis Example 8

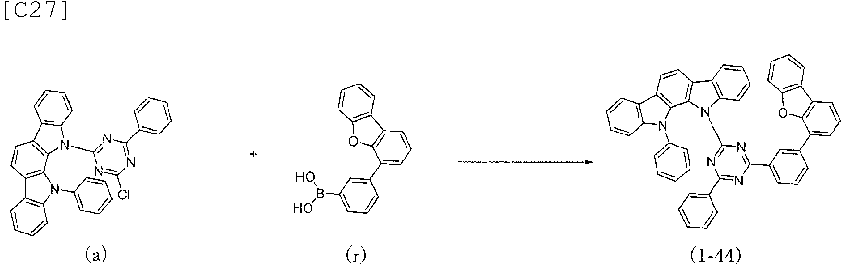

To 12.0 g (23.0 mmol) of compound (a) were added 7.9 g (27.4 mmol) of compound (r), 0.20 g (0.34 mmol) of CX21, 5.5 g (51.7 mmol) of sodium carbonate, 500 g of toluene, 300 g of ethanol, and 50 g of water, and the mixture was stirred under a nitrogen atmosphere at 75°C for 16 hours. The mixture was cooled to room temperature, then 100 mL of water was added, thereafter extraction was performed with toluene as an organic phase, and the organic phase was dried over MgSO₄, and concentrated to dryness to give 17.0 g of a pale yellow solid. The resulting solid was purified by silica gel column chromatography and crystallization to give 7.1 g (9.74 mmol, yield 42%) of compound (1-44) as a yellow solid (APCI-TOFMS, m/z 730 [M+H]⁺).

### Synthesis Example 9

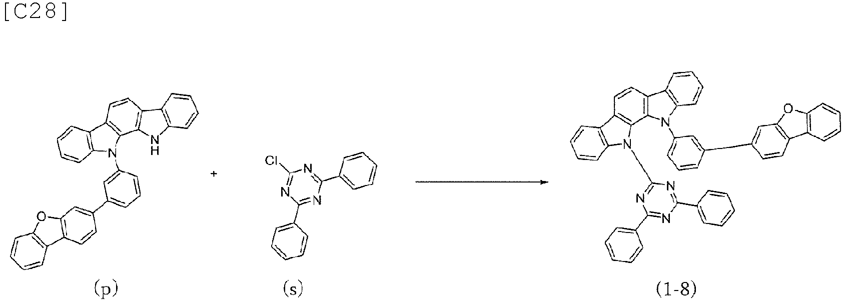

Under a nitrogen atmosphere, 1.1 g of 60 wt% sodium hydride was added to 30 ml of N,N'-dimethylacetamide to prepare a suspension. To this was added 9.9 g (19.9 mmol) of intermediate (p) dissolved in 170 mL of N,N'-dimethylacetamide, and the mixture was stirred for 30 minutes. To this was added 6.4 g (23.9 mmol) of compound (s), and then the mixture was stirred for 1 hour. The reaction solution was added to a solution of methanol (500 mL) mixed with distilled water (500 mL) while being stirred, and the resulting precipitated solid was collected by filtration. Purified was 13.6 g of the resulting solid by silica gel column chromatography and crystallization to give 11.3 g (15.5 mmol, yield 78%) of compound 1-8 as a yellow solid (APCI-TOFMS, m/z 730 [M+H]⁺).

### Synthesis Example 10

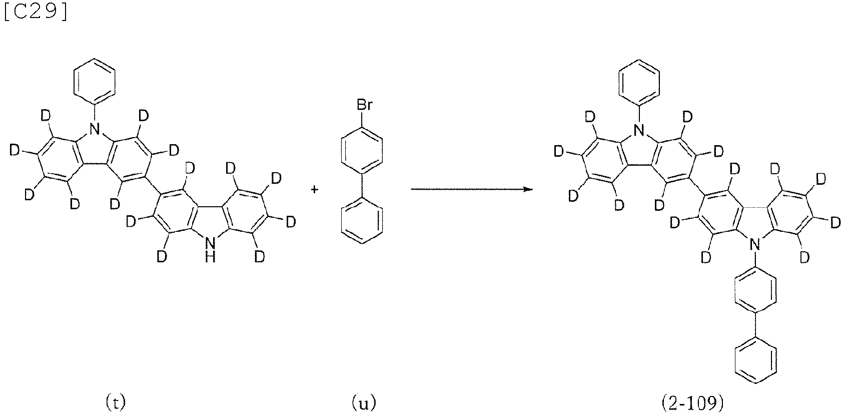

To 3.0 g (7.10 mmol) of compound (t) were added 2.0 g (8.58 mmol) of compound (u), 100 mL of m-xylene, 0.2 g (0.39 mmol) of bis(tri-tert-butylphosphine)palladium, and 4.9 g (35.5 mmol) of potassium carbonate, and the mixture was stirred under a nitrogen atmosphere with heating and reflux for 5 hours. The reaction liquid was cooled, and then subjected to separation and purification to give 1.5 g (2.61 mmol, yield 37%, rate of deuteration 46%) of compound (2-109) as a white solid (APCI-TOFMS, m/z 575 [M+H]⁺).

### Synthesis Example 11

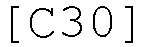

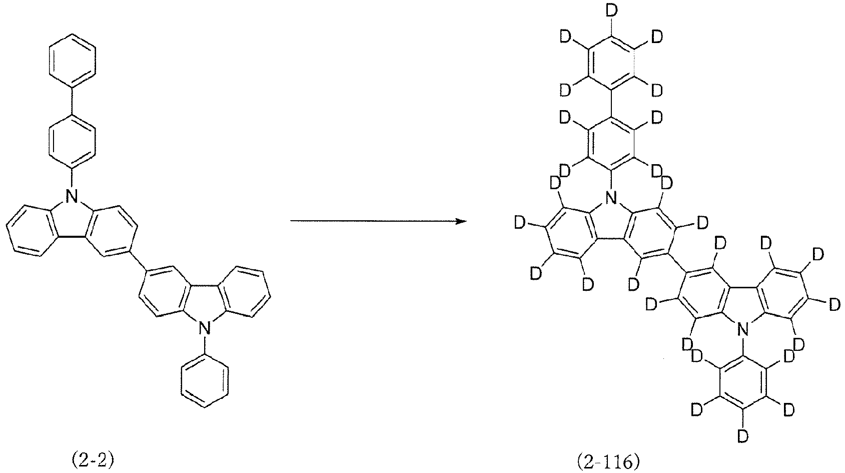

To 8.3 g (14.8 mmol) of compound (2-2) were added 160 mL of deuterated benzene (C₆D₆) and 10.0 g of deuterated trifluoromethanesulfonic acid (TfOD), and the mixture was heated and stirred under a nitrogen atmosphere at 50°C for 6.5 hours. The reaction liquid was added to a solution of sodium carbonate (7.4 g) in deuterated water (200 mL), and the mixture was rapidly cooled, and subjected to separation and purification to give 2.5 g (4.25 mmol, yield 29%, rate of deuteration 79%) of compound (2-116) as a white solid (APCI-TOFMS, m/z 589 [M+H]⁺).

Reaction was performed in the same manner as in Synthesis Example 4 to synthesize compound 1-32 being a deuterated product. The rate of deuteration of compound 1-32 was calculated in the same manner as for compound 1-29, and the result was 90%.

Reaction was performed in the same manner as in Synthesis Example 11 to synthesize compound 2-118 being a deuterated product. The rate of deuteration of compound 2-118 was calculated in the same manner as for compounds 2-109 and 2-116, and the result was 71%.

Compounds used in Examples and Comparative Examples are shown below.

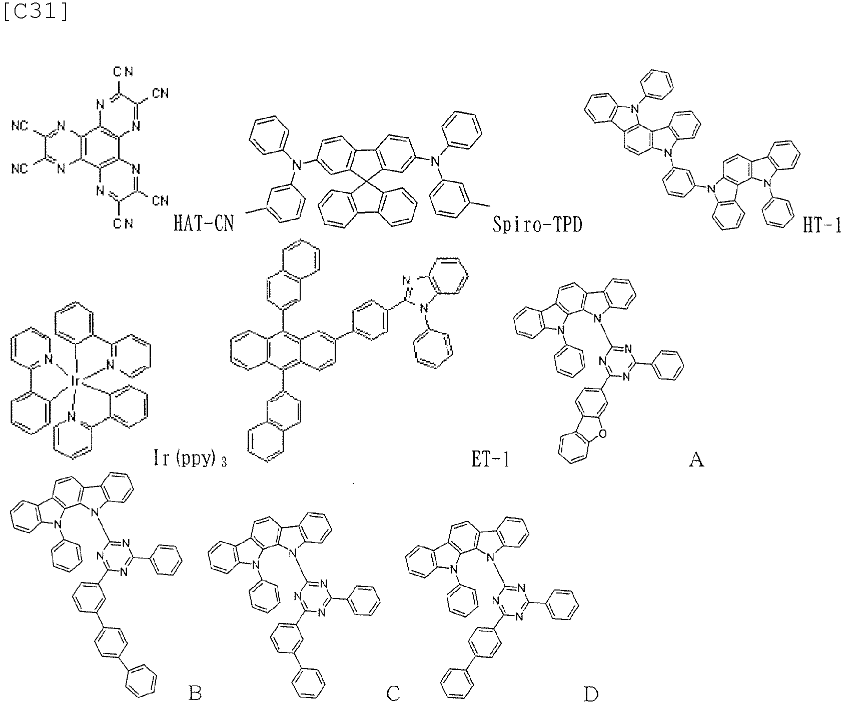

### Example 1

On a glass substrate on which an anode made of ITO with a film thickness of 110 nm was formed, respective thin films were laminated by a vacuum evaporation method at a degree of vacuum of 4.0 × 10⁻⁵ Pa. First, HAT-CN was formed with a thickness of 25 nm as a hole injection layer on ITO, and next, Spiro-TPD was formed with a thickness of 30 nm as a hole transport layer. Next, HT-1 was formed with a thickness of 10 nm as an electron blocking layer. Then, compound 1-1 as a first host, compound 2-2 as a second host, and Ir(ppy)₃ as a light-emitting dopant were co-vapor-deposited from different vapor deposition sources, respectively, to form a light-emitting layer with a thickness of 40 nm. In this case, co-vapor deposition was performed under vapor deposition conditions such that the concentration of Ir(ppy)₃ was 10 wt%, and the weight ratio between the first host and the second host was 30:70. Next, ET-1 was formed with a thickness of 20 nm as an electron transport layer. Further, LiF was formed with a thickness of 1 nm as an electron injection layer on the electron transport layer. Finally, Al was formed with a thickness of 70 nm as a cathode on the electron injection layer to produce an organic EL device.

### Examples 2 to 21

Organic EL devices were produced in the same manner as in Example 1 except that compounds shown in Table 1 were used as the first host and the second host and the weight ratio was as shown in Table 1.

### Examples 22 to 26

Organic EL devices were produced in the same manner as in Example 1 except that a premixture obtained by weighing a first host and a second host shown in Table 1 at a weight ratio shown in Table 1 and mixing them while grinding in a mortar was vapor-deposited from one vapor deposition source.

### Comparative Examples 1 to 6

Organic EL devices were produced in the same manner as in Example 1 except that compounds shown in Table 1 were used as the first host and the second host and the weight ratio was as shown in Table 1.

### Comparative Examples 7 to 12

Organic EL devices were produced in the same manner as in Example 1 except that a premixture obtained by weighing a first host and a second host shown in Table 1 at a weight ratio shown in Table 1 and mixing them while grinding in a mortar was vapor-deposited from one vapor deposition source.

Evaluation results of the produced organic EL devices are shown in Table 1. In the table, the luminance, voltage, and power efficiency are values at a driving current of 10 mA/cm², and they exhibit initial characteristics. LT97 is a time period needed for the luminance to be reduced to 97% of the initial luminance that is assumed to be 100% at a driving current of 20 mA/cm², and it represents lifetime characteristics. The numbers with which the host compound, the first host, and the second host are marked are numbers with which the exemplified compounds are marked, and the weight ratio corresponds to first host : second host.

**[Table 1]**

| | First host | Second host | Weight ratio | Voltage (V) | Luminance (cd/m²) | Power efficiency (Im/W) | LT97 (h) |
|---|---|---|---|---|---|---|---|
| Example 1 | 1-1 | 2-2 | 30:70 | 4.2 | 7900 | 59.1 | 270 |
| Example 2 | 1-3 | 2-2 | 30:70 | 4.3 | 7900 | 57.7 | 280 |
| Example 3 | 1-6 | 2-2 | 30:70 | 4.2 | 7900 | 59.1 | 250 |
| Example 4 | 1-8 | 2-2 | 30:70 | 4.4 | 8000 | 57.1 | 280 |
| Example 5 | 1-13 | 2-2 | 30:70 | 4.2 | 7900 | 59.1 | 270 |
| Example 6 | 1-29 | 2-2 | 30:70 | 4.3 | 7900 | 57.7 | 290 |
| Example 7 | 1-32 | 2-2 | 30:70 | 4.3 | 7900 | 57.7 | 320 |
| Example 8 | 1-43 | 2-2 | 30:70 | 4.3 | 7900 | 57.7 | 200 |
| Example 9 | 1-44 | 2-2 | 30:70 | 4.3 | 8100 | 59.6 | 270 |
| Example 10 | 1-55 | 2-2 | 30:70 | 4.1 | 7900 | 60.5 | 280 |
| Example 11 | 1-57 | 2-2 | 30:70 | 4.2 | 7900 | 59.1 | 280 |
| Example 12 | 1-1 | 2-40 | 30:70 | 4.1 | 7700 | 59.0 | 210 |
| Example 13 | 1-1 | 2-41 | 30:70 | 4.1 | 7700 | 59.0 | 210 |
| Example 14 | 1-1 | 2-42 | 30:70 | 4.1 | 7600 | 58.2 | 210 |
| Example 15 | 1-1 | 2-43 | 30:70 | 4.3 | 7900 | 57.7 | 220 |
| Example 16 | 1-1 | 2-109 | 30:70 | 4.3 | 7900 | 57.7 | 320 |
| Example 17 | 1-1 | 2-116 | 30:70 | 4.3 | 7900 | 57.7 | 340 |
| Example 18 | 1-44 | 2-116 | 30:70 | 4.3 | 8100 | 59.1 | 330 |
| Example 19 | 1-1 | 2-118 | 30:70 | 4.5 | 8100 | 56.5 | 300 |
| Example 20 | 1-1 | 2-2 | 40:60 | 4.0 | 7700 | 60.4 | 240 |
| Example 21 | 1-1 | 2-2 | 50:50 | 3.7 | 7500 | 63.6 | 200 |
| Example 22 | 1-1 | 2-42 | 30:70 | 4.1 | 7900 | 60.5 | 200 |
| Example 23 | 1-1 | 2-43 | 30:70 | 4.3 | 8100 | 59.1 | 210 |
| Example 24 | 1-1 | 2-118 | 30:70 | 4.3 | 8300 | 60.6 | 310 |
| Example 25 | 1-1 | 2-43 | 50:50 | 4.0 | 7700 | 60.4 | 160 |
| Example 26 | 1-1 | 2-118 | 50:50 | 4.0 | 7800 | 61.2 | 230 |
| Comp. Example 1 | A | 2-2 | 30:70 | 3.7 | 6300 | 53.5 | 210 |
| Comp. Example 2 | B | 2-2 | 30:70 | 4.3 | 6300 | 46.0 | 200 |
| Comp. Example 3 | B | 2-43 | 30:70 | 4.1 | 6100 | 46.7 | 150 |
| Comp. Example 4 | B | 2-43 | 50:50 | 3.8 | 6200 | 51.2 | 100 |
| Comp. Example 5 | C | 2-2 | 30:70 | 4.3 | 7200 | 52.6 | 160 |
| Comp. Example 6 | D | 2-2 | 30:70 | 3.7 | 6100 | 51.8 | 230 |
| Comp. Example 7 | A | 2-2 | 30:70 | 3.7 | 6600 | 56.0 | 210 |
| Comp. Example 8 | A | 2-2 | 50:50 | 3.3 | 6200 | 59.0 | 120 |
| Comp. Example 9 | D | 2-2 | 30:70 | 3.7 | 6400 | 54.3 | 220 |
| Comp. Example 10 | D | 2-2 | 50:50 | 3.3 | 6100 | 58.0 | 130 |
| Comp. Example 11 | B | 2-43 | 30:70 | 4.1 | 6500 | 49.8 | 160 |
| Comp. Example 12 | B | 2-43 | 50:50 | 3.8 | 6600 | 54.5 | 120 |

From the results in Table 1, it is understood that Examples 1 to 26 improved the power efficiency and the lifetime and exhibited good characteristics, as compared with Comparative Examples.

Table 2 shows the temperature at 50% weight loss (T₅₀) of compounds 1-1, 2-2, 2-42, 2-43, and 2-118, and compound A, D.

**[Table 2]**

| Compound | T₅₀[°C] |
|---|---|
| 1-1 | 289 |
| 2-2 | 266 |
| 2-42 | 292 |
| 2-43 | 296 |
| 2-118 | 296 |
| A | 269 |
| D | 262 |

### Industrial Applicability

According to the present invention, a first host having indolocarbazole, a nitrogen-containing six-membered ring, and a phenyldibenzofuran group or phenyldibenzothiophene group and a biscarbazole compound as a second host can be mixed and used to thereby obtain an organic EL device with high efficiency and extended lifetime in spite of having a low voltage.

### Reference Signs List

1 substrate, 2 anode, 3 hole injection layer, 4 hole transport layer, 5 light-emitting layer, 6 electron transport layer, 7 cathode

## Claims

1. An organic electroluminescent device comprising one or more light-emitting layers between an anode and a cathode opposed to each other, wherein at least one of the light-emitting layers contains a first host selected from a compound represented by the following general formula (1), a second host selected from a compound represented by the following general formula (2), and a light-emitting dopant material: 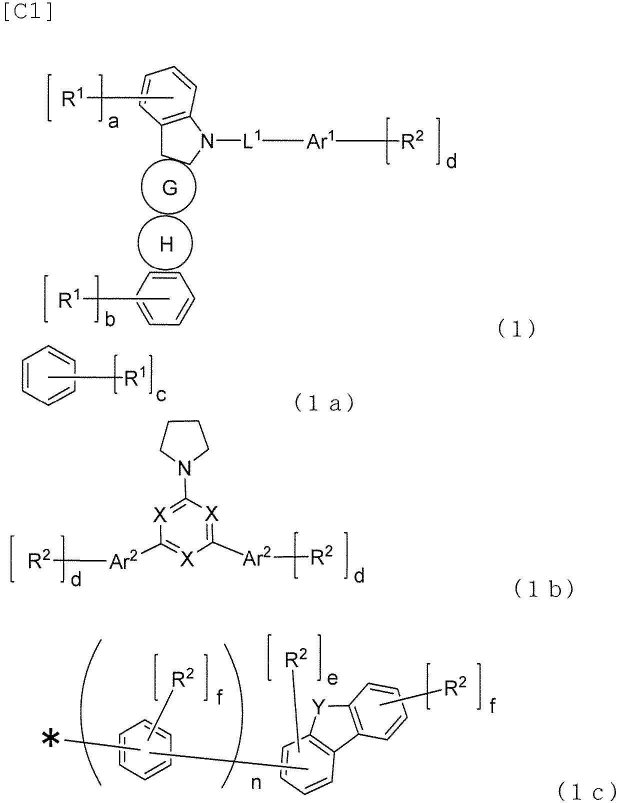
wherein, ring G represents an aromatic ring represented by a formula (1a), and is fused with two adjacent rings; ring H represents a heterocyclic ring represented by a formula (1b), and is fused with two adjacent rings at any positions, but not fused on a side containing N; each X independently represents N, C-H, or C-R, and at least one thereof represents N; and Y represents O or S,
Ar¹ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other,
Ar² independently represents a substituted or unsubstituted aromatic hydrocarbon group having 6 to 17 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other, provided that at least one of Ar¹ and two Ar² represents a group represented by a formula (1c), and "*" indicates a bonding position,
L¹ represents a single bond, a substituted or unsubstituted aromatic hydrocarbon group having 6 to 18 carbon atoms, or a substituted or unsubstituted aromatic heterocyclic group having 3 to 17 carbon atoms, each R¹ independently represents deuterium, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other, provided that when R¹ is an aromatic hydrocarbon group, R¹ is optionally fused with the benzene ring to which R¹ is bonded to form a ring,
each R² independently represents deuterium or an aliphatic hydrocarbon group having 1 to 10 carbon atoms, a to f represent the number of substitutions, a and b each independently represent an integer of 0 to 4, c represents an integer of 0 to 2, each d independently represents an integer of 0 to 13, e represents an integer of 0 to 3, each f independently represents an integer of 0 to 4, and n represents the number of repetitions and an integer of 1 to 4, 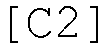 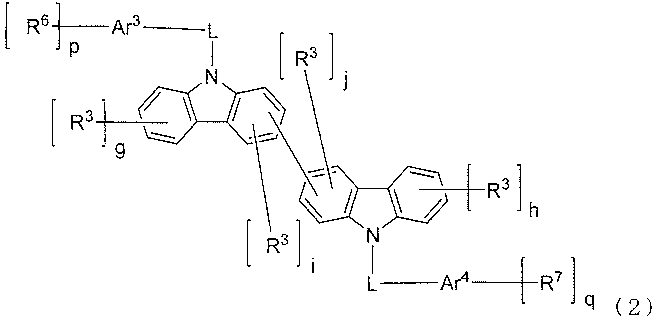
wherein, Ar³ and Ar⁴ each independently represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of these aromatic groups are linked to each other; each L independently represents a single bond, a substituted or unsubstituted aromatic hydrocarbon group having 6 to 18 carbon atoms, or a substituted or unsubstituted aromatic heterocyclic group having 3 to 17 carbon atoms, and R³, R⁶, and R⁷ each independently represent deuterium or an aliphatic hydrocarbon group having 1 to 10 carbon atoms;
and g to j and p to q represent the number of substitutions, g and h each independently represent an integer of 0 to 4, i and j each independently represent an integer of 0 to 3, and p and q each independently represent 0 to 12.

2. The organic electroluminescent device according to claim 1, wherein all of X represent N.

3. The organic electroluminescent device according to claim 1, wherein at least one of Ar² is represented by any of formulas (3) to (5): 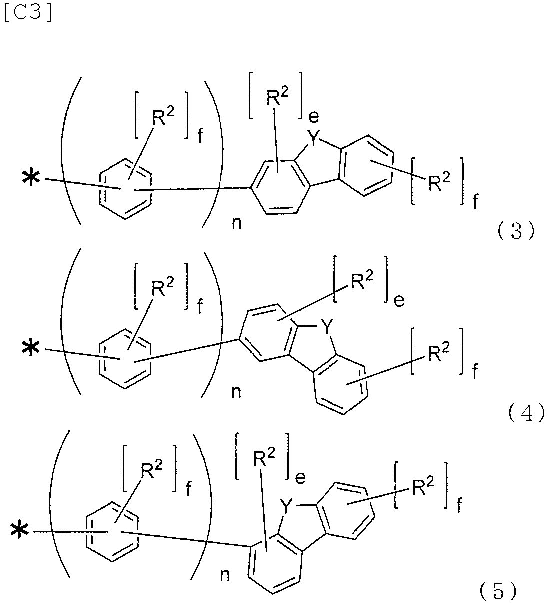 wherein, *, Y, R², e, f, and n are as defined for the general formula (1c).

4. The organic electroluminescent device according to claim 3, wherein at least one of Ar² is represented by the formula (3).

5. The organic electroluminescent device according to claim 1, wherein Y represents O.

6. The organic electroluminescent device according to claim 1, wherein the compound represented by the general formula (1) is represented by any of the following formulas (6) to (9): 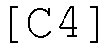 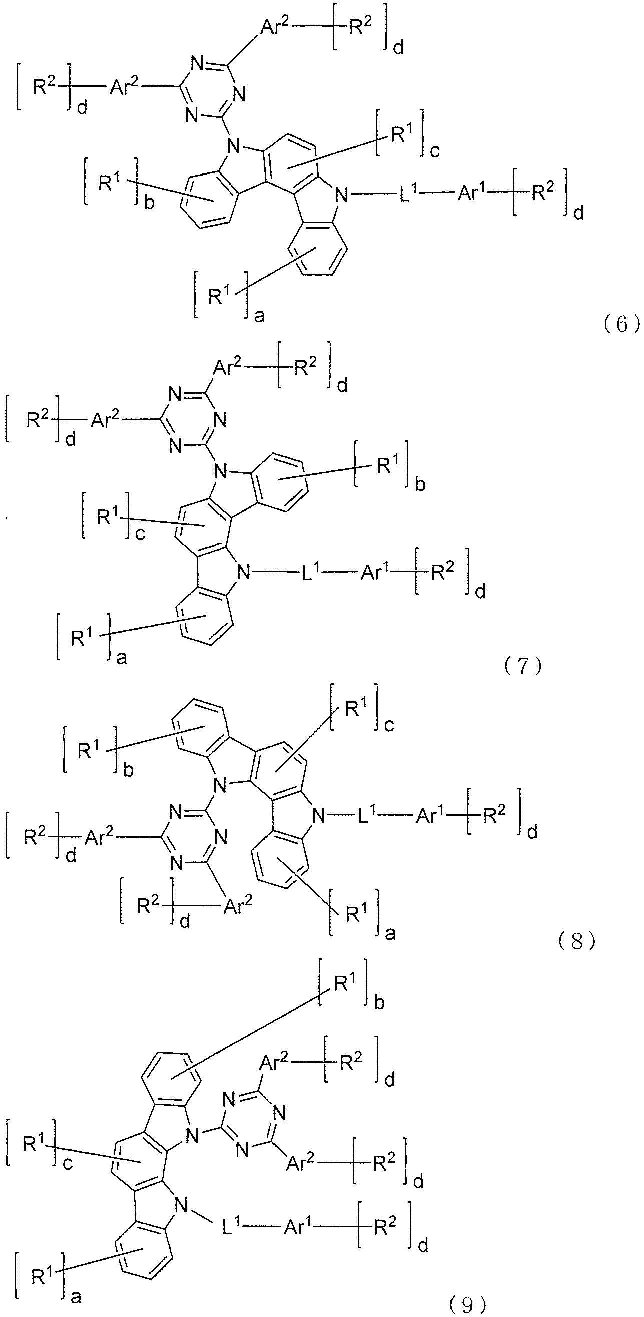 wherein, Ar¹, Ar², L¹, R¹, R², a, b, c, and d are as defined for the general formula (1).

7. The organic electroluminescent device according to claim 1, wherein R¹ represents deuterium.

8. The organic electroluminescent device according to claim 1, wherein R² represents deuterium.

9. The organic electroluminescent device according to claim 1, wherein the general formula (2) is represented by the following formula (10): 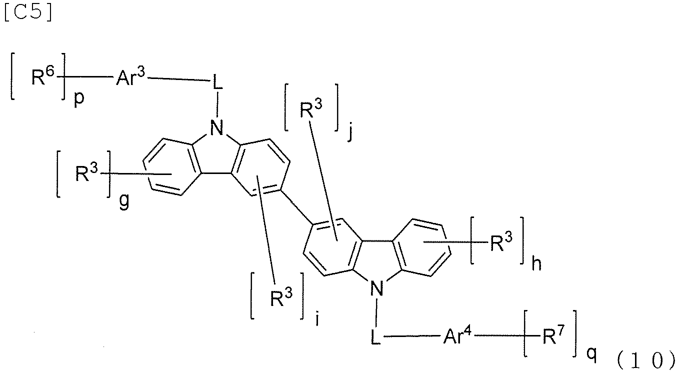 wherein, Ar³, Ar⁴, L, R³, R⁶, R⁷, g to j, and p to q are as defined for the general formula (2).

10. The organic electroluminescent device according to claim 1, wherein Ar³ and Ar⁴ each independently represent a substituted or unsubstituted phenyl group, a substituted or unsubstituted biphenyl group, or a substituted or unsubstituted terphenyl group.

11. The organic electroluminescent device according to claim 1, wherein R³ represents deuterium.

12. The organic electroluminescent device according to any one of claims 1 to 11, wherein the light-emitting dopant material is an organic metal complex containing at least one metal selected from ruthenium, rhodium, palladium, silver, rhenium, osmium, iridium, platinum and gold.

13. The organic electroluminescent device according to any one of claims 1 to 11, wherein the light-emitting dopant material is a thermally activated delayed fluorescence-emitting dopant material.

14. A premixture comprising a first host and a second host to be used for forming a light-emitting layer for an organic electroluminescent device comprising a light-emitting layer containing hosts and a light-emitting dopant material between an anode and a cathode opposed to each other, wherein the first host is selected from a compound represented by the following general formula (1) and the second host is selected from a compound represented by the following general formula (2): 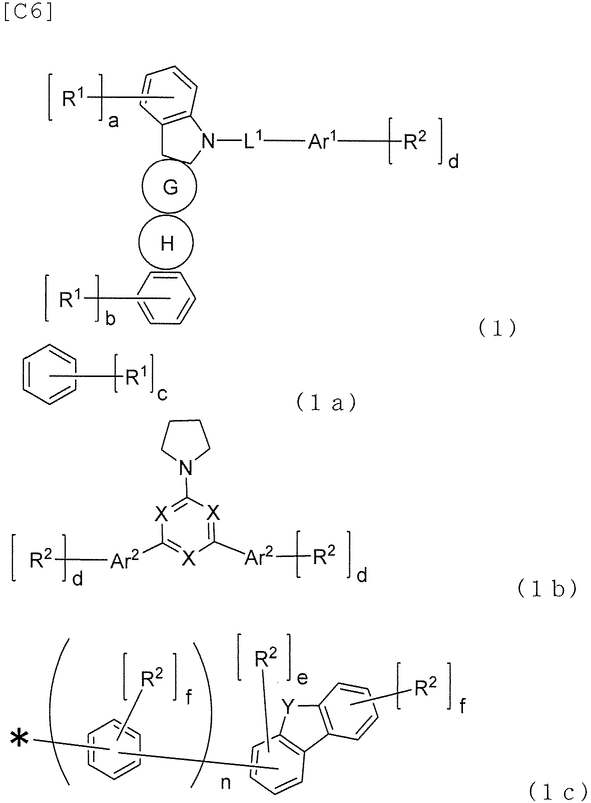
wherein, ring G represents an aromatic ring represented by a formula (1a), ring H represents a heterocyclic ring represented by a formula (1b),
each X independently represents N, C-H, or C-R, and at least one thereof represents N; and Y represents O or S, Ar¹ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other,
each Ar² independently represents a substituted or unsubstituted aromatic hydrocarbon group having 6 to 17 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other, provided that at least one of Ar¹ and two Ar² represents a group represented by a formula (1c),
each L independently represents a single bond, a substituted or unsubstituted aromatic hydrocarbon group having 6 to 18 carbon atoms, or a substituted or unsubstituted aromatic heterocyclic group having 3 to 17 carbon atoms, each R¹ independently represents deuterium, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five aromatic rings of aromatic groups selected from such an aromatic hydrocarbon group and such an aromatic heterocyclic group are linked to each other, provided that when R¹ is an aromatic hydrocarbon group, R¹ is optionally fused with the benzene ring to which R¹ is bonded to form a ring; and each R² independently represents deuterium or an aliphatic hydrocarbon group having 1 to 10 carbon atoms,
a to f represent the number of substitutions, a and b each independently represent an integer of 0 to 4, c represents an integer of 0 to 2, each d independently represents an integer of 0 to 13, e represents an integer of 0 to 3, each f independently represents an integer of 0 to 4, and n represents the number of repetitions and an integer of 1 to 4, 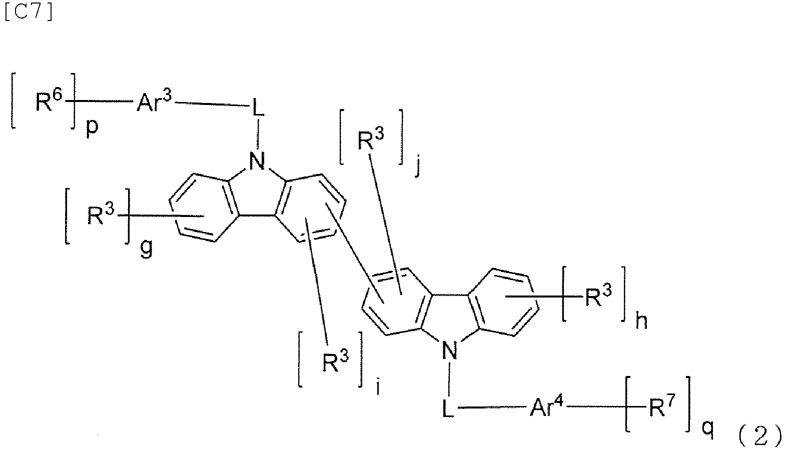
wherein, Ar³ and Ar⁴ each independently represent an aromatic hydrocarbon group having 6 to 18 carbon atoms, an aromatic heterocyclic group having 3 to 17 carbon atoms, or a substituted or unsubstituted linked aromatic group in which two to five of these aromatic groups are linked to each other; each L independently represents a single bond, a substituted or unsubstituted aromatic hydrocarbon group having 6 to 18 carbon atoms, or a substituted or unsubstituted aromatic heterocyclic group having 3 to 17 carbon atoms, and R³, R⁶, and R⁷ each independently represent deuterium or an aliphatic hydrocarbon group having 1 to 10 carbon atoms; and g to j and p to q represent the number of substitutions, g and h each independently represent an integer of 0 to 4, i and j each independently represent an integer of 0 to 3, and p and q each independently represent 0 to 12.

15. The premixture according to claim 14, wherein a difference in temperature at 50% weight loss of the first host and the second host is within 20°C.

16. A method for producing the organic
electroluminescent device according to any one of claims 1 to 13, comprising a step of mixing the first host and the second host to give a premixture and then vapor-depositing a host material containing the premixture to form a light-emitting layer.
